(19) Europäisches Patentamt / European Patent Office / Office européen des brevets

(11) **EP 1 770 867 B1**

(12) **EUROPEAN PATENT SPECIFICATION**

(45) Date of publication and mention
of the grant of the patent:
**31.05.2017 Bulletin 2017/22**

(51) Int Cl.:
***H03M 1/38*** (2006.01)

(21) Application number: **06015726.0**

(22) Date of filing: **27.07.2006**

(54) **Capacitive digital to analog and analog to digital converters**

Kapazitiver Digital Analog Wandler und Analog Digital Wandler

Convertisseur numérique-analogique et Convertisseur analogique-numérique capacitif

(84) Designated Contracting States:
**DE FR GB**

(30) Priority: **08.09.2005 US 715078 P**
**05.12.2005 US 293917**
**06.07.2006 US 481476**
**06.07.2006 US 481477**

(43) Date of publication of application:
**04.04.2007 Bulletin 2007/14**

(73) Proprietor: **Marvell World Trade Ltd.**
**St. Michael 14027 (BB)**

(72) Inventor: **Sutardja, Sehat**
**Los Altos Hills**
**California 94022 (US)**

(74) Representative: **Grünecker Patent- und**
**Rechtsanwälte**
**PartG mbB**
**Leopoldstraße 4**
**80802 München (DE)**

(56) References cited:
WO-A-01/84717    WO-A-2005/041418
JP-A- 10 075 176    US-A1- 2003 080 893
US-A1- 2005 078 026    US-B1- 6 441 765
US-B1- 6 822 601    US-B1- 6 839 015

• RUNHUA SUN ET AL: "A pipelined A/D converter
for high-speed and high-resolution application"
IEEE, 2002, pages I-917-I-920, XP002406058

**Description**

CROSS-REFERENCE TO RELATED APPLICATIONS

This application claims the benefit of U.S. Provisional Application No. 60/715,078, filed on September 8, 2005.

FIELD OF THE INVENTION

The present invention relates to digital to analog (D/A) and analog to digital (A/D) converters, and more particularly to capacitive and/or resistive D/A and A/D converters.

BACKGROUND OF THE INVENTION

Digital to analog (D/A) converters can include arrays of capacitors that are selectively switched to convert a digital signal to an analog counterpart. However, mismatch between capacitors may cause the D/A converter to be non-monotonic. Monotonicity in a D/A converter means that as the digital input to the converter increases over a full-scale range, the analog output never exhibits a decrease between one conversion step and a subsequent conversion step. In other words, the slope of the transfer characteristic is never negative in a monotonic converter.

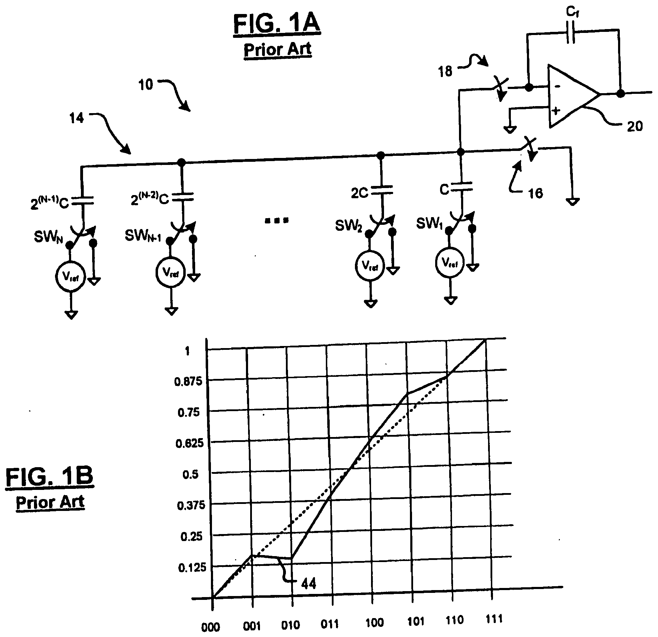

Referring now to FIG. 1A, a D/A converter 10 is shown. The D/A converter 10 includes a binary capacitor array 14, switches 16 and 18, an operational amplifier (opamp) 20, and a capacitor $C_f$ in a feedback arrangement with the opamp 20. Each of the capacitors in the array 14 have different values. More particularly, each capacitor in the array 14 is twice the value of the preceding capacitor. Switches SW selectively switch the capacitors in the array 14 between a voltage reference and a reference potential such as ground.

In use, the D/A converter 10 has sampling and integration stages. In the sampling stage, the switch 16 closes and selective ones of the capacitors are charged to the voltage reference as determined by the switches. In the integrating phase, the switch 16 is opened and the analog output is generated. For example, a four bit array may close a first or most significant bit (MSB) switch and a least significant bit (LSB) switch to represent 9/16 of a voltage reference.

Referring now to FIG. 1B, a non-monotonic output of a D/A converter is shown. For example, the analog output exhibits a decrease from one conversion step to the subsequent conversion step as shown at in FIG. 1 B at 44. The non-monotonic output may be due to capacitor mismatch. For example, the capacitor $2^{N-1}C$ may be different than $2^{N-2}C + 2^{N-3}C + ... + 2C + C$. Ideally, $2^{N-1}C - (2^{N-2}C + 2^{N-3}C + ... + 2C + C) = C$. In other words, the difference between the MSB capacitor and the rest of the capacitors should be equal to a smallest or LSB capacitor

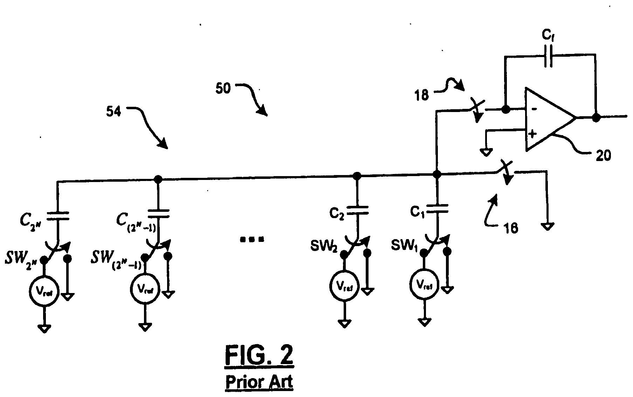

Referring now to FIG. 2, a D/A converter 50 including a linear capacitor array 54 is shown. The linear capacitor array 54 includes $2^N-1$ capacitors that are selectively switched between a voltage reference and reference and reference potential such as ground. While the linear capacitor array 54 inherently monotonic, the number of switches required grows exponentially with the bit resolution. For example, a 16-bit digital to analog converter includes $2^{16}-1$ pairs of switches, which may be impractical.

US 6 839 015 B1 shows a schematic of two exemplary converter stages of a multistage pipelined analog-to-digital converter. Only two stages are shown, but it could contain more stages. Each converter stage includes a switch capacitor circuit which operates in accordance with a two cycle clock. During a first clock cycle first switches are closed and second switches are open, whereas during the second clock cycle first switches are open and second switches are closed. The charge stored at the input capacitors of the first stage is integrated by the operational amplifier of the first stage to generate a residual output voltage $V_{out1}$, which serves as the input voltage to the second stage.

US 2005/078026 A1 relates to a pipelined analog-to-digital conversion system which is provided with cascaded multi bit successive approximation register sub-converter stages. Capacitor arrays are provided in the subconverter stages, where switching logic selectively couples the capacitors to operate in sample, conversion, and residue amplification modes for generating multi-bit subconverter digital outputs and analag subconverter residue outputs. In one implementation, the capacitors are switched according to a thermometer code to reduce differential converter non-linearity, and the first subconverter stage gain is reduced to improve the conversion system bandwidth.

US 2003/080893 A1 relates to a capacitor mismatch independent gain stage for differential pipeline analog to digital converters. The virtual elimination of capacitor mismatch effects is achieved without trading comparator offset margin by an appropriate selection of comparator circuits' reference signals and the inclusion of a plurality of capacitors switched into an appropriate feedback position. This position in the switched capacitor amplifier circuit is determined based on the operating region. In the first operating mode, the capacitor circuits are coupled to the circuit ground potential through switching circuit SW1. The third capacitor circuit is discharged through switching circuits SW1 and SW11, and the first and second capacitor circuits are coupled to the analog input signal such that they follow the input signal.

WO 2005/041418 A discloses a dual residue pipelined AD converter comprising a cascade of, preferable balanced, switched capacitor dual reside converter stages for producing from first and second residue input signals one of more digital bits and first and second residue output signals for application to the next stage in the cascade. The first and second residue input signals change input capacitors whose charge is subsequently transferred to output capacitors by means of operational amplifiers. The switched capacitor architecture allows compensation for DC-offset voltages of the operational amplifiers.

The article RUNHUA SUN ET AL.: "A pipelined A/D converter for high-speed and high-resolution application, IEEE, 2002, pages I-917-I-920, XO002406058 relates to a pipelined AD converter architecture which uses the combination of multi-bit-per-stage technique for relaxing the capacitor matching requirement and the strategy employing partitioned residue gain in the first stage to achieve high-speed. matching requirements in terms of the number of bits in the first stage for high-resolution ADC are analytically discussed.

WO 01/84717 A1 discloses a method and apparatus for calibrating a pipeline stage in a multi-bit/stage pipeline A/D converter. A set of D/A converter unit-segments are switched in the stage to predetermined states for producing a first digital signal, and a predetermined unit-segment in the set is switched to its complementary state, keeping the states of the other unit-segments in said set unchanged, for producing a second digital signal. The unit-segment is then associated with a calibration coefficient representing the deviation of the difference between the first and second digital signals from an expected difference between the first and second digital signals. This process is repeated for each unit-segment that is to be calibrated.

US 6,822,601 B1 discloses a multiplying digital-to-analog converter (MDAC) stage, wherein a plurality of second capacitances in parallel are selectively connected between an input node and an amplifier input and between a corresponding plurality of digital reference signals, which can include a pseudo-random first calibration signal, and the amplifier input. A pipelined ADC incorporating a series of such MDAC stages includes a multiplier connected to the last MDAC stage of the series, a low-pass filter for filtering output of the multiplier and outputting a DC component, and an encoder for receiving the output of the MDAC stages and generating a digital signal and for compensating the digital output signal with the DC component. A background calibration of the ADC includes applying the first calibration signal to a second capacitance of the MDAC stage during a hold phase, and filtering the first calibration signal from the digital output of the pipelined analog-to-digital converter.

Document JP 10075176 A relates to an analog/digital converter for reducing the number of required switching elements by selectively connecting one end of a circuit, composed of the plural capacitors of a specified capacitance to a signal bus and obtaining the digital value of voltage signals based on the output of a comparator commonly connected to the other end. Switching elements are closed in a sampling period by timing signals and a first capacitor and a plurality of subsequent capacitances are charged by analog voltage signals. Then the switching elements are opened and a second plurality of switching elements are successively closed by the timing signals, resistors are searched, and signals equivalent to the high-order 4 bits of the digital value to be obtained of the voltage signals are outputted form an operational amplifier. Then, the second plurality of switching elements is successively closed and the signals equivalent to the low-order 4 bits of the digital value are outputted from the operational amplifier. Thus, a register/logic circuit outputs the signals for indicating the digital value of the voltage signals VIN.

US 6,441,765 B1 discloses an analog to digital converter with enhanced differential non-linearity. The bit-and-one-half analog to digital converter comprises a multiplying analog to digital converter (MDAC) operating in cooperation with a comparator which generates a two-bit digital output signal by comparison of an output of the MDAC against a pair of thresholds. The thresholds are stretched outwardly from symmetrical thresholds centered at +/- ¼ of the comparison range.

The above outlined object is solved by the invention as claims in the independent claims. Preferred embodiments of the invention are defined by the dependent claims.

SUMMARY OF THE INVENTION

A digital-to-analog converter (DAC) comprises a capacitive DAC that comprises N first capacitances that are connected in parallel and that have first ends and second ends, wherein N is an integer greater than one, and N first switches that selectively connect a selected one of the second ends of the N first capacitances to a common node and non-selected ones of the second ends of the N first capacitances to one of a voltage potential and a reference potential. Capacitance values of the N first capacitances are substantially equal. A second DAC communicates with the common node.

A digital-to-analog converter (DAC) comprises first converting means for converting a digital signal to an analog signal and that comprises N first capacitance means for providing capacitance that are connected in parallel and that have first ends and second ends, wherein N is an integer greater than one and N first switching means for selectively connecting one of the second ends of the N first capacitance means to a common node and others of the second ends to one of a voltage potential and a reference potential. Capacitance values of the N first capacitance means are substantially equal. Second converting means converts a digital signal to an analog signal and that communicates with the common node.

A method for providing a digital-to-analog converter (DAC) comprises connecting N first capacitances of a first capacitive DAC in parallel, wherein the N first capacitances have first ends and second ends, N is an integer greater than one, and capacitance values of the N first capacitances are substantially equal. The method includes selectively connecting a selected one of the second ends of the N first capacitances to a common node; selectively connecting others of the second ends to one of a voltage potential and a reference potential; and connecting a second DAC to the common node.

A pipelined analog-to-digital converter (ADC) comprises a first stage that receives an input voltage signal and that comprises an analog-to-digital converter (ADC) that includes an amplifier having an input and an output; N capacitances that are connected in parallel and that include first ends that selectively communicate with the input and second ends; N switches that selectively connect the second ends of the N capacitances to the voltage input during a first phase, one of the second ends of the N capacitances to the output of the amplifier during a second phase, and others of the second ends of the N capacitances to one of a voltage reference and a reference potential during the second phase. A second stage communicates with the output the amplifier.

In other features, the first phase is a sampling phase and the second phase is a residue amplification phase. When the input voltage is between zero and a first ratio of a first of the N capacitances divided by a sum of the N capacitances, the first of the N capacitances is connected to the output of the amplifier and others of the N capacitances are connected to the reference potential during the second phase. When the input voltage is between the first ratio and a second ratio of a sum of the first and a second of the N capacitances divided by a sum of the N capacitances, the first of the N capacitances is connected to the voltage reference, the second of the N capacitances is connected to the output of the amplifier and others of the N capacitances are connected to the reference potential during the second phase. When the input voltage is between the second ratio and a third ratio of a sum of the first, the second and a third of the N capacitances divided by a sum of the N capacitances, the first and the second of the N capacitances are connected to the voltage reference, the third of the N capacitances is connected to the output of the amplifier and others of the N capacitances are connected to the reference potential during the second phase.

A pipelined analog-to-digital converter (ADC) comprises first stage means for receiving an input voltage signal and that comprises converting means for converting signals that includes: amplifying means for amplifying and having an input and an output; N capacitance means for providing capacitance, that are connected in parallel and that include first ends that selectively communicate with the input and second ends; and N switching means for selectively connecting the second ends of the N capacitance means to the voltage input during a first phase, one of the second ends of the N capacitance means to the output of the amplifier during a second phase, and others of the second ends of the N capacitance means to one of a voltage reference and a reference potential during the second phase; and second stage means for communicating with the output of the amplifying means of the first stage means.

In other features, the first phase is a sampling phase and the second phase is a residue amplification phase. When the input voltage is between zero and a first ratio of a first of the N capacitances divided by a sum of the N capacitances, the N switching means connect the first of the N capacitances to the output of the amplifier and others of the N capacitances to the reference potential during the second phase. When the input voltage is between the first ratio and a second ratio of a sum of the first and a second of the N capacitances divided by a sum of the N capacitances, the N switching means connect the first of the N capacitances to the voltage reference, the second of the N capacitances to the output of the amplifier and others of the N capacitances to the reference potential during the second phase. When the input voltage is between the second ratio and a third ratio of a sum of the first, the second and a third of the N capacitances divided by a sum of the N capacitances, the N switching means connect the first and the second of the N capacitances to the voltage reference, the third of the N capacitances to the output of the amplifier and others of the N capacitances to the reference potential during the second phase.

A method for generating a residue voltage in a pipelined analog-to-digital converter (ADC) comprises providing first and second stages, wherein the first stage receives a voltage input and includes a capacitive ADC including N capacitances; selectively connecting the second ends of the N capacitances to the voltage input during a first phase; selectively connecting one of the second ends of the N capacitances to the output of the amplifier during a second phase; selectively connecting others of the second ends of the N capacitances to one of a voltage reference and a reference potential during the second phase; selectively connecting the first ends of the N capacitances to an amplifier input; and connecting an amplifier output to the second stage.

In other features, the first phase is a sampling phase and the second phase is a residue amplification phase. The method further comprises selectively connecting the first of the N capacitances to the output of the amplifier and others of the N capacitances to the reference potential during the second phase when the input voltage is between zero and a first ratio of a first of the N capacitances divided by a sum of the N capacitances. The method further comprises selectively connecting the first of the N capacitances to the voltage reference, the second of the N capacitances to the output of the amplifier and others of the N capacitances to the reference potential during the second phase when the input voltage is between the first ratio and a second ratio of a sum of the first and a second of the N capacitances divided by a sum of the N capacitances. The method further comprises selectively connecting the first and the second of the N capacitances to the voltage reference, the third of the N capacitances to the output of the amplifier and others of the N capacitances to the reference potential during the second phase when the input voltage is between the second ratio and a third ratio of a sum of the first, the second and a third of the N capacitances divided by a sum of the N capacitances.

A digital to analog converter (DAC) comprises X capacitive DACs that are connected in series and wherein X is an integer greater than one. Each of the X capacitive DACs comprise M switches wherein M is an integer greater than one; a signal input; a signal output; and M capacitances that communicate with the M switches, respectively, and that have first and second ends and substantially equal capacitance values. The M switches selectively connect the first ends of the M capacitances to the signal output. The M switches connect the second end of a selected one of the M capacitances to the signal input. A first DAC has a signal output that communicates with the signal input of one of the X capacitive DACs.

In other features, an amplifier has an input and an output. A feedback capacitance communicates with the input and the output of the amplifier. The first ends of the M capacitances of another one of the X DACs communicates with a reference potential during a first phase of the another one of the X DACs. The input of the amplifier selectively communicates with the first ends of the M capacitances of the another one of the X DACs during a second phase of the another one of the X DACs.

In other features, an amplifier has an input and an output. The first ends of the M capacitances of another one of the X DACs communicate with a reference potential during a first phase of the another one of the X DACs. The input of the amplifier selectively communicates with the first ends of the M capacitances of the another one of the X DACs during a second phase of the another one of the X DACs. The second ends of the of the M capacitances of the another one of the X DACs communicate with the output of the amplifier during the second phase of the another one of the X DACs. The first DAC comprises Y resistive DACs wherein Y is an integer greater than zero.

In other features, at least one of the Y resistive DACs comprises a signal output; N resistances connected in series between the voltage reference and the reference potential; N nodes between select ones of the N resistances and the reference potential; and N second switches that selectively connect the signal output of the one of the Y resistive DACs to one of the N nodes. A control module selectively generates switching signals to control the X capacitive DACs and the first DAC.

In other features, a successive approximation analog-to-digital converter comprises the DAC. The successive approximation analog-to-digital converter of comprises an amplifier having an input that selectively communicates with one of the X capacitive DACs. A successive approximation module communicates with an output of the amplifier. A decoding module communicates with an output of the successive approximation module and selectively generates switching signals for the X capacitive DACs and the first DAC.

In other features, the first DAC comprises a capacitive DAC. The capacitive DAC comprises a signal output and an amplifier having an input and an output that communicates with the signal output. M second capacitances are connected in parallel and have first ends and second ends. The first ends selectively communicate with a reference potential during a first phase of the capacitive DAC. The first ends selectively communicate with the input of the amplifier during a second phase of the capacitive DAC. M second switches selectively connect the second ends of the M second capacitances to one of the voltage reference and the reference potential during the first phase of the capacitive DAC and selectively connect the second ends of the M second capacitances to the output during the second phase of the capacitive DAC.

A digital to analog converter (DAC) comprises X capacitive converting means for converting a digital signal to an analog signal and that are connected together in series and wherein X is an integer greater than one. Each of the X capacitive converting means comprise M switching means for switching wherein M is an integer greater than one. M capacitance means for providing capacitance communicate with the M switching means, respectively, and have first and second ends and substantially equal capacitance values. The M switching means selectively connect the first ends of the M capacitance means to the signal output. The M switching means connect the second end of a selected one of the M capacitance means to the signal input. First converting means converts a digital signal to an analog signal and has a signal output that communicates with the signal input of one of the X capacitive converting means.

In other features, amplifying means for amplifying and has an input and an output. Feedback capacitance means provides capacitance and communicates with the input and the output of the amplifying means. The first ends of the M capacitance means of another one of the X converting means communicates with a reference potential during a first phase of the another one of the X converting means. The input of the amplifying means selectively communicates with the first ends of the M capacitance means of the another one of the X converting means during a second phase of the another one of the X converting means.

In other features, amplifying means for amplifying has an input and an output. The first ends of the M capacitance means of another one of the X converting means communicates with a reference potential during a first phase of the another one of the X converting means. The input of the amplifying means selectively communicates with the first ends of the M capacitance means of the another one of the X converting means during a second phase of the another one of the X converting means. The second ends of the M capacitance means of the another one of the X converting means communicate with the output of the amplifying means during the second phase of the another one of the X converting means. The first DAC comprises Y resistive converting means for converting a digital signal to an analog signal and wherein Y is an integer greater than zero.

In other features, at least one of the Y resistive converting means comprises a signal output and N resistance means for providing resistance and that is connected in series between the voltage reference and the reference potential. N nodes are located between select ones of the N resistance means and the reference potential. N second switching means selectively connect the signal output of the one of the Y resistive converting means to one of the N nodes. Control means selectively generates switching signals to control the X capacitive converting means and the first DAC.

In other features, a successive approximation analog-to-digital converter comprises the DAC. The successive approximation analog-to-digital converter comprises amplifying means for amplifying and having an input that selectively communicates with one of the X capacitive DACs and approximation means for successive approximating and that communicates with an output of the amplifying means. Decoding means communicates with an output of the successive approximation module for selectively generating switching signals for the X capacitive DACs and the first DAC.

In other features, the first DAC comprises a capacitive converting means for converting a digital signal to an analog signal. The capacitive converting means comprises a signal output and amplifying means for amplifying and having an input and an output that communicates with the signal output. M second capacitance means provides capacitance and is connected in parallel and has first ends and second ends. The first ends selectively communicate with a reference potential during a first phase of the capacitive DAC. The first ends selectively communicate with the input of the amplifying means during a second phase of the capacitive DAC. M second switching means selectively connect the second ends of the M second capacitance means to one of the voltage reference and the reference potential during the first phase of the capacitive DAC and selectively connect the second ends of the M second capacitance means to the output during the second phase of the capacitive DAC.

A method for operating a digital to analog converter (DAC) comprises connecting X capacitive DACs in series and wherein X is an integer greater than one, wherein each of the X capacitive DACs comprise M capacitances that have first and second ends and substantially equal capacitance values; selectively connecting the first ends of the M capacitances to the signal output; connecting the second end of a selected one of the M capacitances to the signal input; and connecting a signal output of a first DAC to the signal input of one of the X capacitive DACs.

In other features, the method comprises providing an amplifier having an input and an output and a feedback capacitance that communicates with the input and the output of the amplifier. The method comprises connecting the first ends of the M capacitances of another one of the X DACs with a reference potential during a first phase of the another one of the X DACs. The method comprises selectively connecting the input of the amplifier to the first ends of the M capacitances of the another one of the X DACs during a second phase of the another one of the X DACs.

In other features, the method comprises providing an amplifier having an input and an output; selectively connecting the first ends of the M capacitances of another one of the X DACs with a reference potential during a first phase of the another one of the X DACs; selectively connecting the input of the amplifier with the first ends of the M capacitances of the another one of the X DACs during a second phase of the another one of the X DACs; and selectively connecting the second ends of the of the M capacitances of the another one of the X DACs communicate with the output of the amplifier during the second phase of the another one of the X DACs.

In other features, the first DAC comprises Y resistive DACs wherein Y is an integer greater than zero. The method comprises selectively generating switching signals to control the X capacitive DACs and the first DAC. The method comprises using the X capacitive DACs to successively approximate an analog input signal. The first DAC comprises a capacitive DAC.

Further areas of applicability of the present invention will become apparent from the detailed description provided hereinafter. It should be understood that the detailed description and specific examples, while indicating the preferred embodiment of the invention, are intended for purposes of illustration only and are not intended to limit the scope of the invention.

## BRIEF DESCRIPTION OF THE DRAWINGS

The present invention will become more fully understood from the detailed description and the accompanying drawings, wherein:

FIG. 1A is an electrical schematic of a binary capacitor array D/A converter according to the prior art;
FIG. 1B is a graph of a D/A converter;
FIG. 2 is an electrical schematic of a linear capacitor array D/A converter according to a prior art;
FIGs. 3A-3C are electrical schematics of a capacitive-resistive D/A converter in exemplary configurations;
FIG. 4A illustrates the D/A converter of FIG. 3B during a sampling phase for a first digital value;
FIG. 4B illustrates the D/A converter of FIG. 3B during an integrating phase for a first digital value;

FIG. 4C is an exemplary truth table for the circuit of FIG. 3B;

FIG. 4D is an exemplary truth table for the circuit of FIG. 3C;

FIG. 5 illustrates the D/A converter of FIG. 3B during a sampling phase for a second digital value;

FIG. 6 illustrates the D/A converter of FIG. 3B during a sampling phase for a third digital value;

FIG. 7 illustrates the D/A converter of FIG. 3B during a sampling phase for a fourth digital value;

FIG. 8A is an electrical schematic of a capacitive-capacitive D/A converter;

FIG. 8B is an electrical schematic of a capacitive-capacitive D/A converter in a sample and integrate configuration;

FIG. 8C illustrates the D/A converter of FIG. 8B during a sampling phase for a first digital value;

FIG. 8D illustrates the D/A converter of FIG. 8B during an integrating phase for a first digital value;

FIG. 8E illustrates the D/A converter of FIG. 8B during a sampling phase for a second digital value;

FIG. 8F illustrates the D/A converter of FIG. 8B during a sampling phase for a third digital value;

FIG. 8G illustrates the D/A converter of FIG. 8B during a sampling phase for a fourth digital value;

FIG. 8H is an exemplary timing diagram showing sampling and integrating phases for LSB and MSB portions;

FIG. 8I is an exemplary timing diagram showing sampling and integrating phases for LSB and MSB portions;

FIG. 8J is an exemplary truth table for the D/A converter of FIG. 8B;

FIG. 9A illustrates an N-stage capacitive D/A converter;

FIG. 9B illustrates an N-stage capacitive-resistive D/A converter;

FIG. 9C is an exemplary timing diagram showing non-overlapping sampling and integrating phases for additional stages;

FIG. 9D is an exemplary timing diagram showing overlapping sampling and integrating phases for additional stages;

FIG. 10 is an electrical schematic of a successive approximation A/D converter;

FIG. 11A is an electrical schematic of a pipelined A/D converter according to the present invention;

FIG. 11 B-11 D illustrate ideal and non-ideal residue voltages;

FIG. 12A illustrates an A/D converter that generates an ideal residue voltage according to the present invention;

FIG. 12B illustrates the A/D converter of FIG. 12A in a sampling phase;

FIG. 12C illustrates the A/D converter of FIG. 12A in a residue amplification stage for a first voltage input value;

FIG. 12D is an exemplary truth table for the A/D converter of FIG. 12A;

FIG. 13 illustrates the A/D converter of FIG. 12A in a residue amplification stage for a second voltage input value;

FIG. 14 illustrates the A/D converter of FIG. 12A in a residue amplification stage for a third voltage input value;

FIG. 15 illustrates the A/D converter of FIG. 12A in a residue amplification stage for a fourth voltage input value;

FIG. 16 is a graph illustrating variable interstage gain and an ideal residue voltage of the circuit of FIG. 12A;

FIG. 17A is a functional block diagram of a hard disk drive;

FIG. 17B is a functional block diagram of a digital versatile disk (DVD);

FIG. 17C is a functional block diagram of a high definition television;

FIG. 17D is a functional block diagram of a vehicle control system;

FIG. 17E is a functional block diagram of a cellular phone;

FIG. 17F is a functional block diagram of a set top box; and

FIG. 17G is a functional block diagram of a media player.

## DETAILED DESCRIPTION OF THE PREFERRED EMBODIMENTS

The following description of the preferred embodiment(s) is merely exemplary in nature and is in no way intended to limit the invention, its application, or uses. For purposes of clarity, the same reference numbers will be used in the drawings to identify similar elements. As used herein, the term module, circuit and/or device refers to an Application Specific Integrated Circuit (ASIC), an electronic circuit, a processor (shared, dedicated, or group) and memory that execute one or more software or firmware programs, a combinational logic circuit, and/or other suitable components that provide the described functionality. As used herein, the phrase at least one of A, B, and C should be construed to mean a logical (A or B or C), using a non-exclusive logical or. It should be understood that steps within a method may be executed in different order without altering the principles of the present invention.

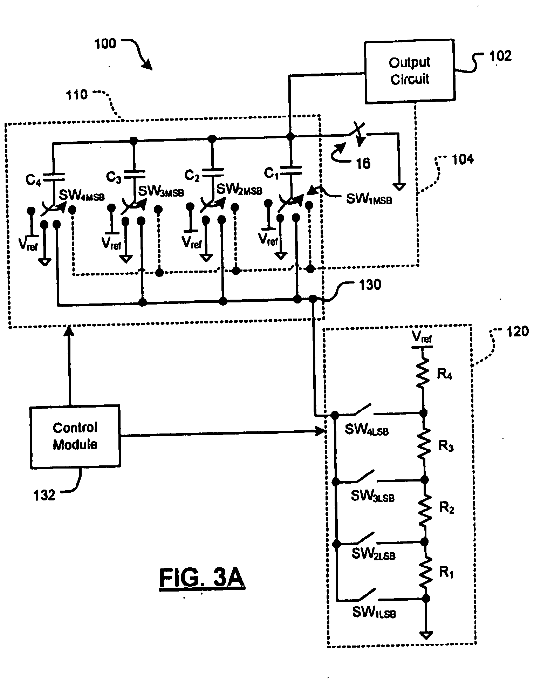

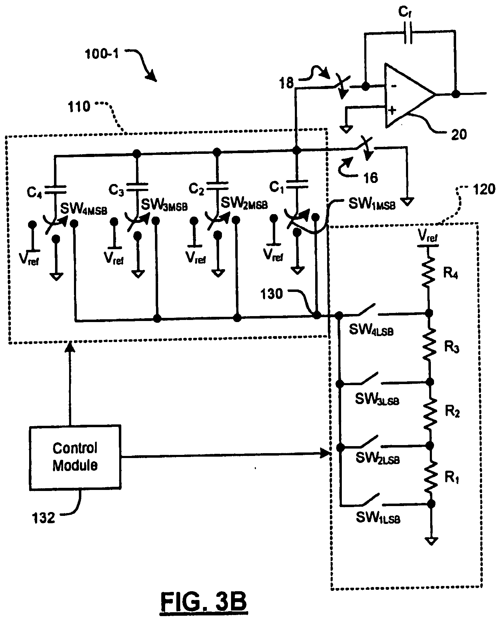

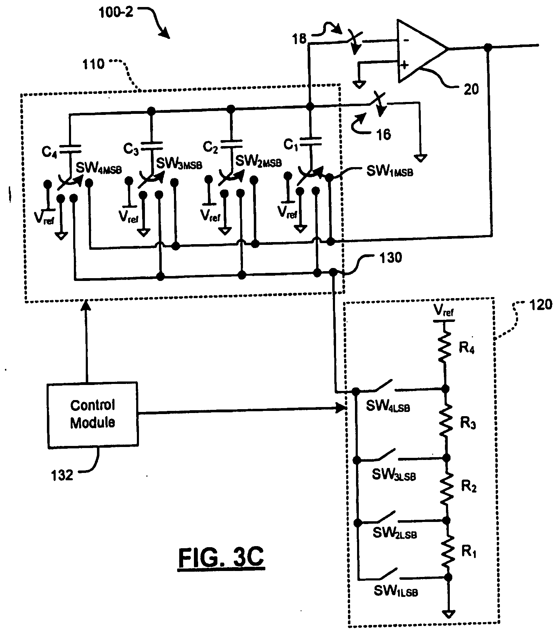

Referring now to FIG. 3A and 3B, capacitive-resistive D/A converters 100, 100-1 and 100-2 are shown. For simplicity, an N=4 bit example is shown in FIGs. 3A-3C. Skilled artisans will appreciate that N can be set to other numbers of bits. Various types of output circuits 102 may be used. Additional connections 104, which may or may not be switched connections, may be used depending upon the function that is desired. For example in FIG. 3B, the DAC 100-1 is shown in a sample and integrate configuration and in FIG. 3C, a DAC 100-2 is shown with a sample and hold configuration.

In this example, the two most significant bits (MSBs) are allocated to a capacitive portion 110 and the two least significant bits (LSBs) are allocated to a resistive portion 120. In the Figures that follow, the capacitor $C_f$ will be shown with dotted lines to indicate both sample and hold and sample and integrate configurations.

The capacitive portion 110 includes capacitors $C_1$, $C_2$, $C_3$ and $C_4$. In the preferred embodiment, the capacitors

$C_1$, $C_2$, $C_3$ and $C_4$ have a substantially equal capacitance value. The capacitors may have substantially the same capacitance value, in other words $C_1 = C_2 = C_3 = C_4$. As will be described further below, the capacitors are selectively switched by switches $SW_{4MSB}$, $SW_{3MSB}$, $SW_{2MSB}$, and $SW_{1MSB}$ (collectively switches $SW_M$) between a voltage reference $V_{ref}$, a reference potential such as ground, and a common node 130 between the resistive portion 120 and the capacitive portion 110.

The resistive portion 110 includes resistors $R_1$, $R_2$, $R_3$ and $R_4$. In the preferred embodiment, the resistors $R_1$, $R_2$, $R_3$ and $R_4$ have a substantially equal resistance value. The resistors may have the same resistance value, in other words $R_1 = R_2 = R_3 = R_4$. As will be described further below, the resistors are connected in series between $V_{ref}$ and a reference potential such as ground. A node between the resistors is selected by switches $SW_{4LSB}$, $SW_{3LSB}$, $SW_{2LSB}$, and $SW_{1LSB}$ (collectively switches $SW_L$) and connected to the common node 130 to create a voltage divider.

The sample and integrate circuit was described above. In the sample and hold configuration, the second ends of the capacitances $C_1$, $C_2$, $C_3$ and $C_4$ are switched to the output of the amplifier during the second phase of the capacitive portion 110. The feedback capacitance $C_f$ may be omitted.

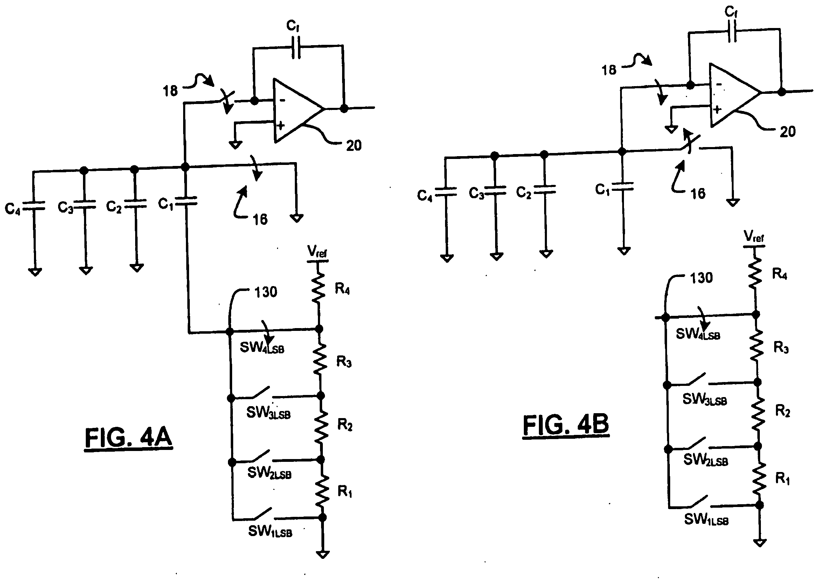

Referring now to FIG. 4A, the D/A converter of FIG. 3B is shown during a sampling phase for a first digital value (0011). Initially, the switch 16 is closed, the switch 18 is opened and the capacitors $C_2$, $C_3$ and $C_4$ are switched by respective switches to the reference potential, which may be ground. The capacitor $C_1$ is connected to the common node. The capacitive portion 110 will be in this configuration when the desired binary value is between 0000 and 0011. One of the resistive switches $SW_{4LSB}$, $SW_{3LSB}$, $SW_{2LSB}$, and $SW_{1LSB}$ is closed to create a voltage divider. In the example shown in FIG. 4A, the switch $SW_{4LSB}$ is closed to provide $\frac{3}{4}V_{ref}$. A charge is accumulated on the capacitor $C_1$ that is equal to $V_{RDAC}C_1$, where $V_{RDAC}$ is the voltage provided by the resistive portion 120.

Referring now to FIG. 4B, the D/A converter of FIG. 3B is shown during an integrating phase for the first digital value (0011). In this phase, the switch 16 is opened, the switch 18 is closed and the voltage value is applied to the amplifier 20. Using a charge equalization approach, the total charge before changing the position of the switches 16 and 18 is equal to the total charge after changing the position of the switches 16 and 18:

$$Q_T = VC_f = V_{RDAC}C_1;$$

$$V = V_{RDAC}\frac{C_1}{C_f}.$$

The value of $C_f$ can be set equal to $C_1$, $C_2$, $C_3$ and $C_4$ or be used to scale the output voltage and not be equal to $C_1$, $C_2$, $C_3$ and $C_4$. In the example above, $V_{RDAC} = \frac{3}{4}V_{ref}$. As can be appreciated, the value can also be adjusted to

$V_{RDAC} = 0, V_{RDAC} = \frac{1}{4}V_{ref}$, or $V_{RDAC} = \frac{1}{2}V_{ref}$ by selecting the switch $SW_{1LSB}$, $SW_{2LSB}$ or $SW_{3LSB}$, respectively.

Scaling can be performed by adjusting the value of $C_f$ relative to $C_1$, $C_2$, $C_3$ and $C_4$. For example, if $Cf = C_1 + C_2 + C_3 + C_4$, then the output ranges 0 to near $V_{ref}$ rather than 0 to near 4 $V_{ref}$ in this example.

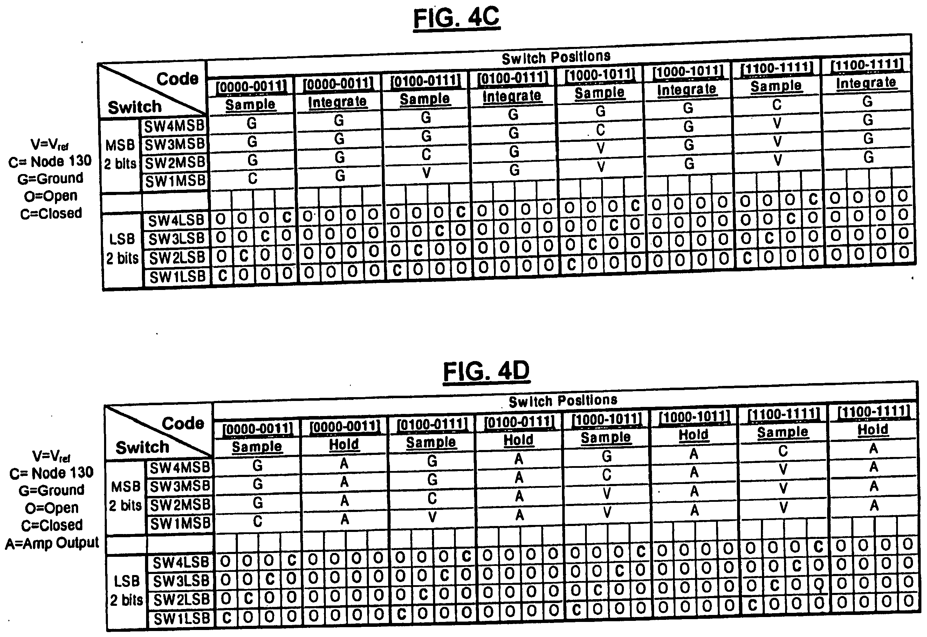

Referring now to FIG. 4C, a truth table for the exemplary converter of FIG. 3B is shown. In this example, $C_f$ is equal to $C_1$, $C_2$, $C_3$ and $C_4$ although other values may be used for scaling. Referring now to FIG. 4D, a truth table for the exemplary converter of FIG. 3C is shown.

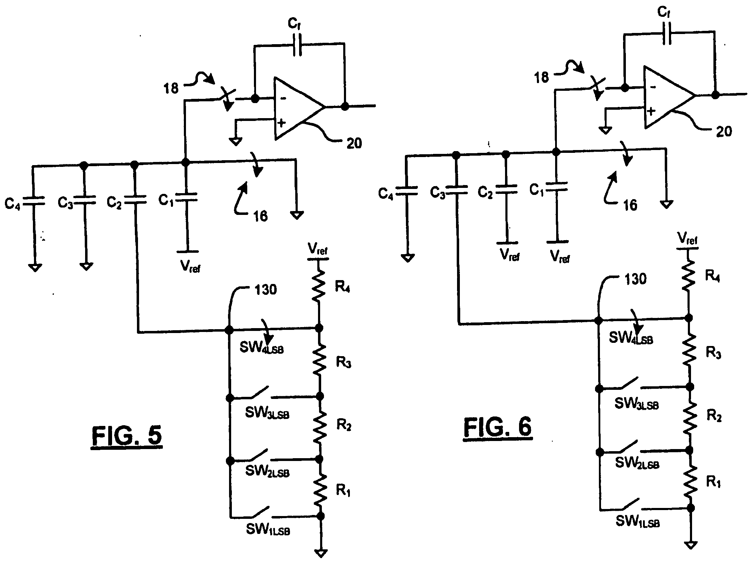

Referring now to FIG. 5, the D/A converter of FIG. 3B is shown during an integrating phase for a second digital value (0111). Initially, the switch 16 is closed, the switch 18 is opened and the capacitors $C_3$ and $C_4$ are switched by respective switches to the reference potential, which may be ground. The capacitor $C_2$ is connected to the common node 130 and the capacitor $C_1$ is connected to $V_{ref}$. The capacitive portion 110 will be in this configuration when the desired binary value is between 0100 and 0111. One of the resistive switches $SW_{4LSB}$, $SW_{3LSB}$, $SW_{2LSB}$, and $SW_{1LSB}$ is closed to create a voltage divider. In the example shown in FIG. 5, the switch $SW_{4LSB}$ is closed to provide $\frac{3}{4}V_{ref}$. A charge is accumulated on the capacitor $C_2$ that is equal to $V_{RDAC}C_2$, where $V_{RDAC}$ is the voltage provided by the resistive portion. A charge is also accumulated on capacitor $C_1$ equal to $V_{ref}C_1$.

During an integrating phase for the second digital value (0111), the switch 16 is opened, the switch 18 is closed and the voltage value is applied to the amplifier 20. Using a charge equalization approach, the total charge before changing the position of the switches 16 and 18 is equal to the total charge after changing the position of the switches 16 and 18:

$$Q_T = VC_f = V_{RDAC}C_2 + V_{ref}C_1;$$

$$V = V_{RDAC}\frac{C_2}{C_f} + V_{ref}\frac{C_1}{C_f}.$$

The value of $C_f$ can be set equal to $C_1$, $C_2$, $C_3$ and $C_4$ or be used to scale the output voltage and not be equal to $C_1$, $C_2$, $C_3$ and $C_4$. If $C_f$, $C_1$ and $C_2$ are the same, $V = V_{RDAC} + V_{ref}$.

Referring now to FIG. 6, the D/A converter of FIG. 3B is shown during an integrating phase for a third digital value (1011). Initially, the switch 16 is closed, the switch 18 is opened and the capacitor $C_4$ is switched by a respective switch to the reference potential, which may be ground. The capacitor $C_3$ is connected to the common node 130 and the capacitors $C_1$ and $C_2$ are connected to $V_{ref}$. The capacitive portion 110 will be in this configuration when the desired binary value is between 1000 and 1011. One of the resistive switches $SW_{4LSB}$, $SW_{3LSB}$, $SW_{2LSB}$, and $SW_{1LSB}$ is closed to create a voltage divider. In the example shown in FIG. 6, the switch $SW_{4LSB}$ is closed to provide $\frac{3}{4}V_{ref}$. A charge is accumulated on the capacitor $C_3$ that is equal to $V_{RDAC}C_3$, where $V_{RDAC}$ is the voltage provided by the resistive portion. A charge is also accumulated on capacitors $C_1$ and $C_2$ that is equal to $V_{ref}(C_1 + C_2)$.

During an integrating phase for the third digital value (1011). the switch 16 is opened, the switch 18 is closed and the voltage value is applied to the amplifier 20. Using a charge equalization approach, the total charge before changing the position of the switches 16 and 18 is equal to the total charge after changing the position of the switches 16 and 18:

$$Q_T = VC_f = V_{RDAC}C_3 + V_{ref}(C_1 + C_2);$$

$$V = V_{RDAC}\frac{C_3}{C_f} + V_{ref}\frac{C_1 + C_2}{C_f}.$$

The value of $C_f$ can be set equal to $C_1$, $C_2$, $C_3$ and $C_4$ or be used to scale the output voltage and not be equal to $C_1$, $C_2$, $C_3$ and $C_4$. If $C_f$. $C_1$, $C_2$ and $C_3$ are the same, $V = V_{RDAC} + 2V_{ref}$.

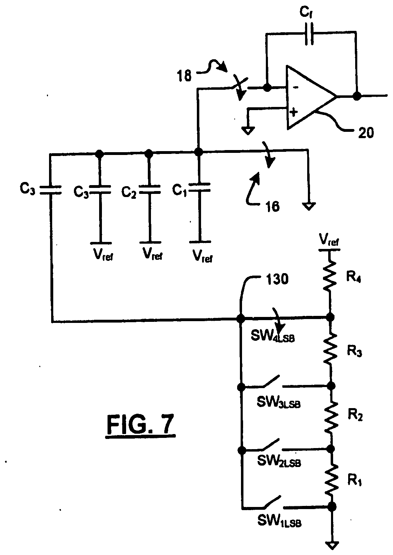

Referring now to FIG. 7, the D/A converter of FIG. 3B is shown during an integrating phase for a third digital value (1111). Initially, the switch 16 is closed and the switch 18 is opened. The capacitor $C_4$ is connected to the common node 130 and the capacitors $C_1$, $C_2$ and $C_3$ are connected to $V_{ref}$. The capacitive portion 110 will be in this configuration when the desired binary value is between 1100 and 1111. One of the resistive switches $SW_{4LSB}$, $SW_{3LSB}$, $SW_{2LSB}$, and $SW_{1LSB}$ is closed to create a voltage divider. In the example shown in FIG. 7, the switch $SW_{4LSB}$ is closed to provide $\frac{3}{4}V_{ref}$. A charge is accumulated on the capacitor $C_4$ that is equal to $V_{RDAC}C_4$, where $V_{RDAC}$ is the voltage provided by the resistive portion. A charge is accumulated on capacitors $C_1$, $C_2$ and $C_3$ that is equal to $V_{ref}(C_1 + C_2 + C_3)$.

During an integrating phase for the fourth digital value (1111). the switch 16 is opened, the switch 18 is closed and the voltage value is applied to the amplifier 20. Using a charge equalization approach, the total charge before changing the position of the switches 16 and 18 is equal to the total charge after changing the position of the switches 16 and 18:

$$Q_T = VC_f = V_{RDAC}C_4 + V_{ref}(C_1 + C_2 + C_3);$$

$$V = V_{RDAC}\frac{C_4}{C_f} + V_{ref}\frac{C_1 + C_2 + C_3}{C_f}.$$

The value of $C_f$ can be set equal to $C_1$, $C_2$, $C_3$ and $C_4$ or be used to scale the output voltage and not be equal to $C_1$, $C_2$, $C_3$ and $C_4$. If $C_f$, $C_1$, $C_2$, $C_3$ and $C_4$ are the same, $V = V_{RDAC} + 3V_{ref}$.

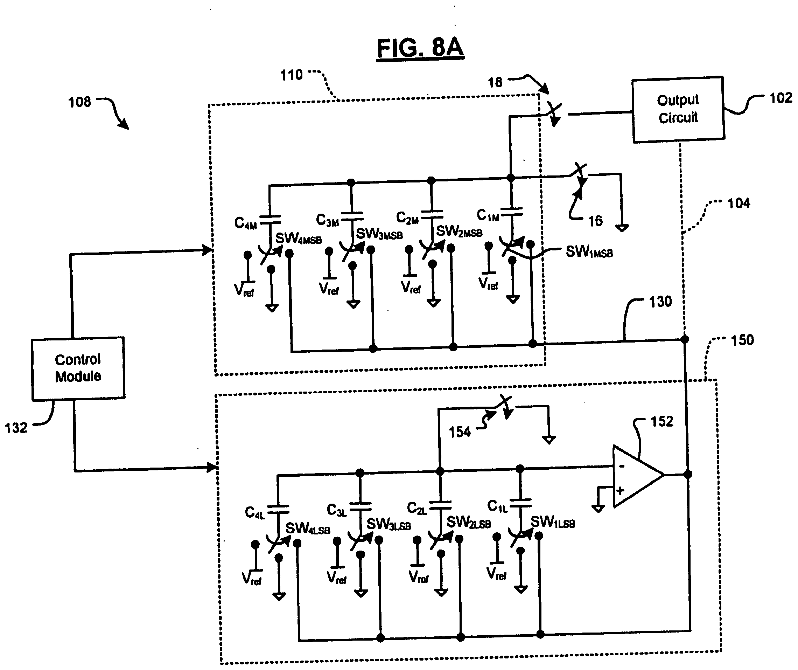

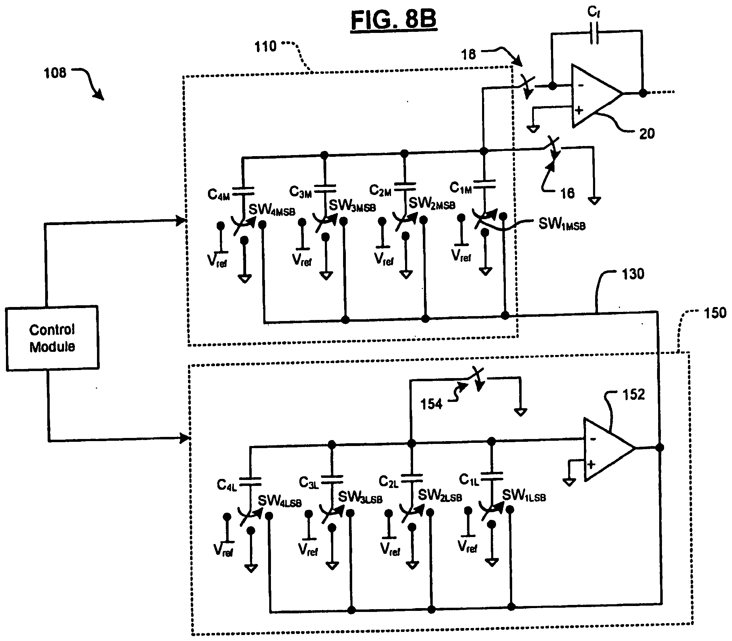

Referring now to FIG. 8A and 8B, a nested segmented capacitive-capacitive D/A converter 108 according to the present invention is shown. In FIG. 8A, the output circuit 102 is shown. In FIG. 8B, an exemplary sample and integrate configuration is shown. The capacitive portion 110 operates as described above. For purposes of clarity, the capacitors $C_1$, $C_2$, $C_3$ and $C_4$ have been relabeled $C_{1M}$, $C_{2M}$, $C_{3M}$ and $C_{4M}$. A second capacitive portion 150 is associated with the two least significant bits and includes capacitors $C_{1L}$, $C_{2L}$, $C_{3L}$ and $C_{4L}$. The voltage provided by the LSB capacitive portion 150 is $V_{CDAC}$. The second capacitive portion 150 also has a sampling and integrating phase as will be described below.

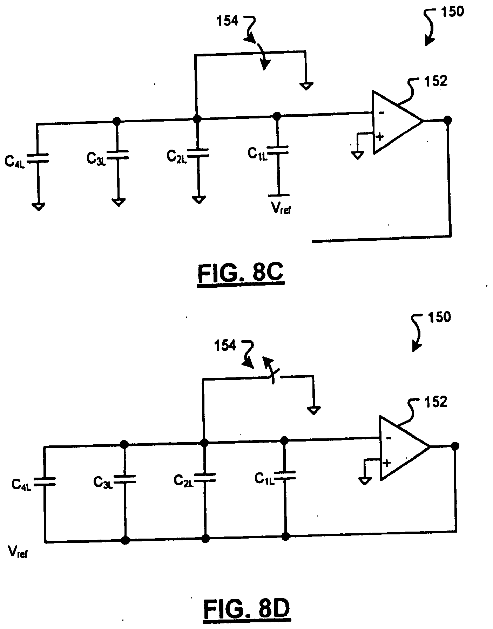

Referring now to FIGs. 8C and 8D, an equivalent circuit of the D/A converter of FIG. 8B during a sampling phase is shown for $V_{CDAC} = \dfrac{V_{ref}}{4}$. During sampling phase, the switch 152 is closed and the capacitors $C_{4L}$, $C_{3L}$ and $C_{2L}$ are connected to a reference potential such as ground. The capacitor $C_{1L}$ is charged to $V_{ref}$. A charge is accumulated on the capacitor $C_{1L}$ that is equal to $V_{ref}C_{1L}$.

During the integrating phase, the switch 152 is opened and the capacitors $C_{4L}$, $C_{3L}$, $C_{2L}$ and $C_{1L}$ are connected in feedback. The total charge before the switch 152 is opened is the same as the total charge after the switch 152 is opened. Therefore:

$$Q_T = VC_T = V_{ref}C_{1L} = V(C_{1L} + C_{2L} + C_{3L} + C_{4L});$$

$$V = V_{ref}\frac{C_{1L}}{C_{1L} + C_{2L} + C_{3L} + C_{4L}}.$$

Assuming that $C_{1L}$, $C_{2L}$, $C_{3L}$ and $C_{4L}$ are equal, $V = \dfrac{V_{ref}}{4}$.

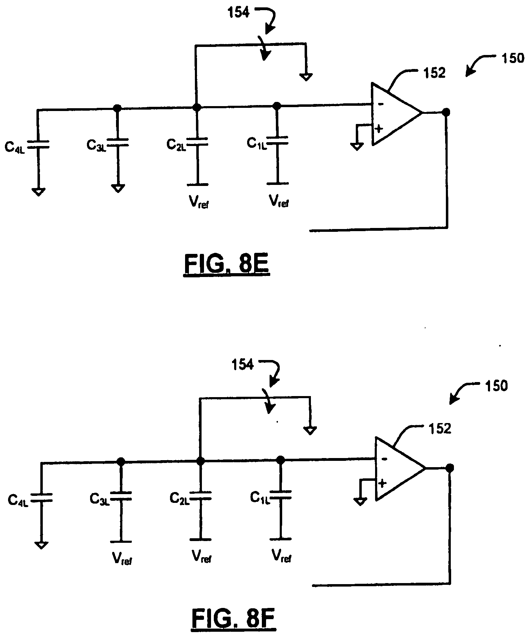

Referring now to FIG. 8E, an equivalent circuit of the D/A converter of FIG. 8B during a sampling phase is shown for $V_{CDAC} = \dfrac{V_{ref}}{2}$. During sampling phase, the switch 152 is closed and the capacitors $C_{4L}$ and $C_{3L}$ are connected to a reference potential such as ground. The capacitors $C_{1L}$ and $C_{2L}$ are charged to $V_{ref}$. A charge is accumulated on the capacitors $C_{1L}$ and $C_{2L}$ that is equal to $V_{ref}(C_{1L} + C_{2L})$.

During the integrating phase, the switch 152 is opened and the capacitors $C_{4L}$, $C_{3L}$, $C_{2L}$ and $C_{1L}$ are connected in feedback. The total charge before the switch 152 is opened is the same as the total charge after the switch 152 is opened. Therefore:

$$Q_T = VC_T = V_{ref}(C_{1L} + C_{2L}) = V(C_{1L} + C_{2L} + C_{3L} + C_{4L});$$

$$V = V_{ref}\frac{C_{1L} + C_{2L}}{(C_{1L} + C_{2L} + C_{3L} + C_{4L})}.$$

Assuming that $C_1$, $C_2$, $C_3$ and $C_4$ are equal, $V = \dfrac{V_{ref}}{2}$.

Referring now to FIG. 8F, an equivalent circuit of the D/A converter of FIG. 8B during a sampling phase is shown for $V_{CDAC} = \dfrac{3V_{ref}}{4}$. During sampling phase, the switch 152 is closed and the capacitor $C_{4L}$ is connected to a reference potential such as ground. The capacitors $C_{1L}$, $C_{2L}$ and $C_{3L}$ are charged to $V_{ref}$. A charge is accumulated on the capacitors $C_{1L}$, $C_{2L}$ and $C_{3L}$ that is equal to $V_{ref}(C_{1L} + C_{2L} + C_{3L})$.

During the integrating phase, the switch 152 is opened and the capacitors $C_{4L}$, $C_{3L}$, $C_{2L}$ and $C_{1L}$ are connected in feedback. The total charge before the switch 152 is opened is the same as the total charge after the switch 152 is opened. Therefore:

$$Q_T = VC_T = V_{ref}(C_{1L} + C_{2L} + C_{3L}) = V(C_{1L} + C_{2L} + C_{3L} + C_{4L});$$

$$V = V_{ref}\frac{C_{1L} + C_{2L} + C_{3L}}{(C_{1L} + C_{2L} + C_{3L} + C_{4L})}.$$

Assuming that $C_{1L}$, $C_{2L}$, $C_{3L}$ and $C_{4L}$ are equal, $V = \dfrac{3V_{ref}}{4}$.

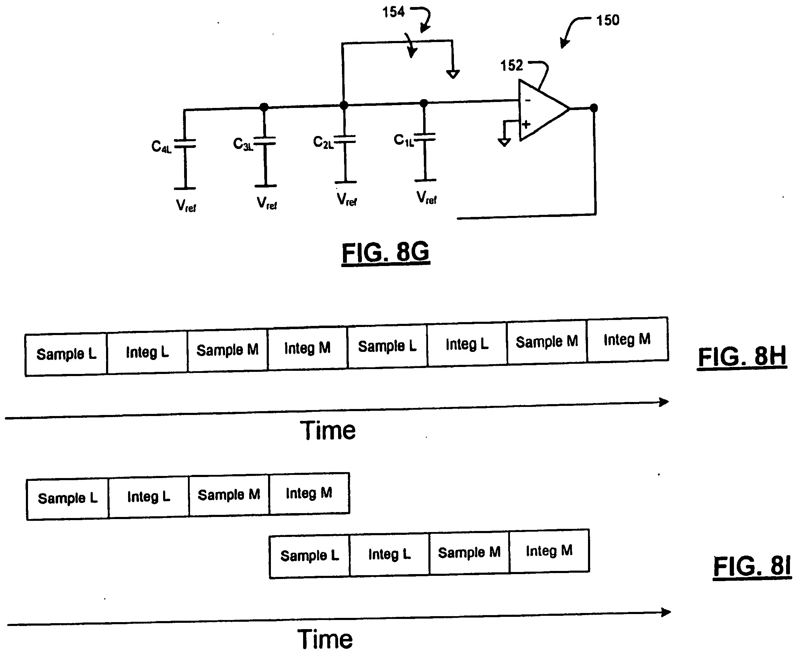

Referring now to FIG. 8G, an equivalent circuit of the D/A converter of FIG. 8B during a sampling phase is shown for $V_{CDAC} = V_{ref}$. The switch associated with this position may be omitted since this value can be already be obtained by using the next MSB. In this case one of the capacitors may always be connected to ground. If a switch is used, during sampling phase the switch 152 is closed and the capacitors $C_{1L}$, $C_{2L}$, $C_{3L}$ and $C_{4L}$ are charged to $V_{ref}$. A charge is accumulated on the capacitors $C_{1L}$, $C_{2L}$, $C_{3L}$ and $C_{4L}$ that is equal to $V_{ref}(C_{1L} + C_{2L} + C_{3L} + C_{4L})$.

During the integrating phase, the switch 152 is opened and the capacitors $C_{4L}$, $C_{3L}$, $C_{2L}$ and $C_{1L}$ are connected in feedback. The total charge before the switch 152 is opened is the same as the total charge after the switch 152 is opened. Therefore:

$$Q_T = VC_T = V_{ref}(C_{1L} + C_{2L} + C_{3L} + C_{4L}) = V(C_{1L} + C_{2L} + C_{3L} + C_{4L});$$

$$V = V_{ref}\frac{C_{1L} + C_{2L} + C_{3L} + C_{4L}}{(C_{1L} + C_{2L} + C_{3L} + C_{4L})}.$$

Assuming that $C_{1L}$, $C_{2L}$, $C_{3L}$ and $C_{4L}$ are equal, $V = V_{ref}$.

Referring now to FIGs. 8H and 8I, non-overlapping and overlapping timing diagrams are shown for sampling and integrating phases for LSB and MSB capacitive portions. The timing of the sampling and integrating phases can be non-overlapping as shown in FIG. 8H. Alternately, the sampling phase of the LSB capacitive portion can fully and/or partially overlap the integrating phase of the MSB capacitive portion as shown in FIG. 8I.

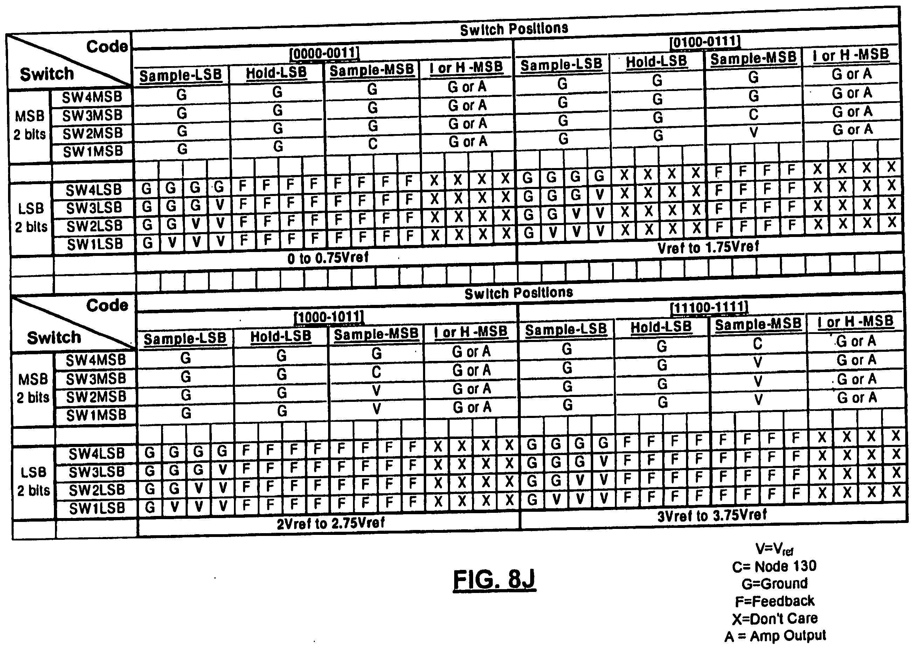

Referring now to FIG. 8J, a truth table for the D/A converter is shown. As can be appreciated, the LSB switches can be connected in feedback and/or to ground during the MSB-integrating phase and/or can begin the next LSB sampling phase as described herein.

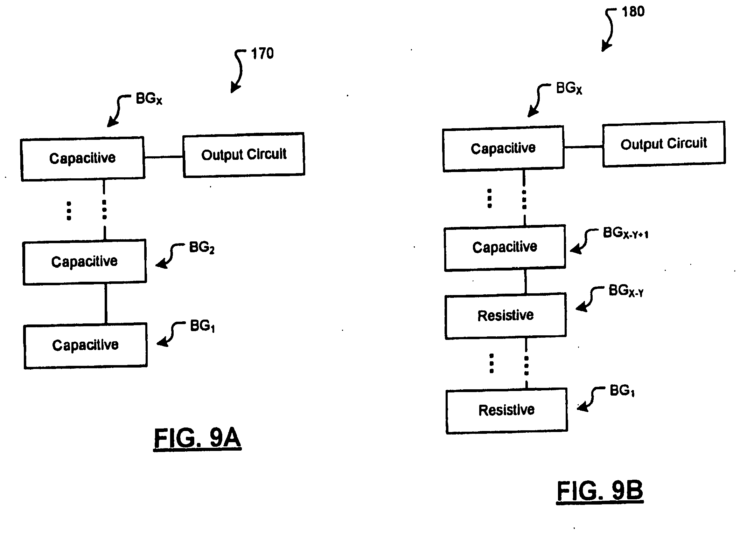

Referring now to FIG. 9A-9D, additional capacitive and/or resistive DAC portions may be added. In FIG. 9A, an N stage capacitive D/A converter 170 is shown. The converter 170 includes capacitive portions $BG_1$, $BG_2$, ..., and $BG_X$, which are associated with LSB, next LSB, ..., and MSB groups. For example, a 6 bit example can include capacitive portions $BG_1$, $BG_2$ and $BG_3$. Each capacitive portion may include four capacitors as shown and described above. Each of the capacitive portions includes sampling and integrating stages that may be non-overlapping and/or overlapping as described above and below.

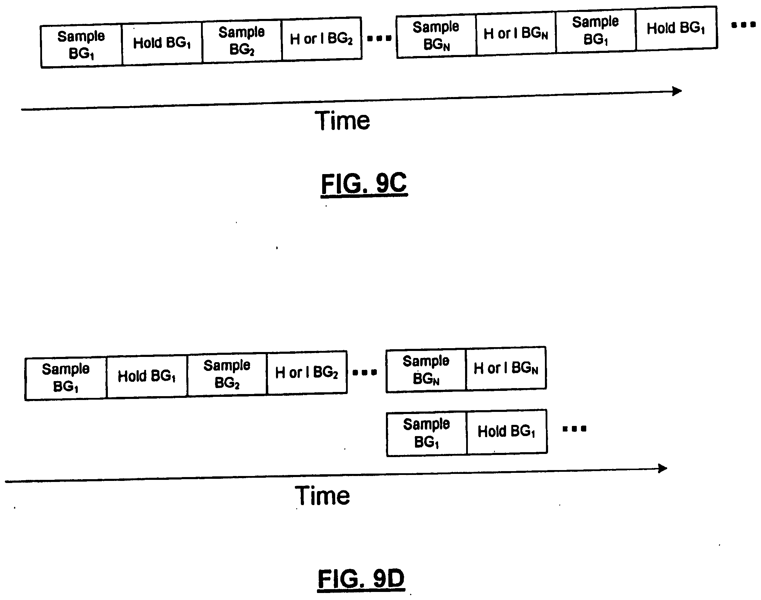

In FIG. 9B, an N stage capacitive-resistive D/A converter 180 is shown. One or more of the last stages is a resistive portion as described above. In this example, there are X-Y capacitive portions and Y resistive portions, where X and Y are integers greater than zero. When resistive portions are used, the sampling and integrating phases for the last capacitive stage and the final resistive stage can be the same as described above. In FIG. 9C, an exemplary timing diagram shows non-overlapping sampling and integrating phases for additional capacitive stages. In FIG. 9D, an exemplary timing diagram showing fully and/or partially overlapping sampling and integrating phases for additional capacitive stages is shown.

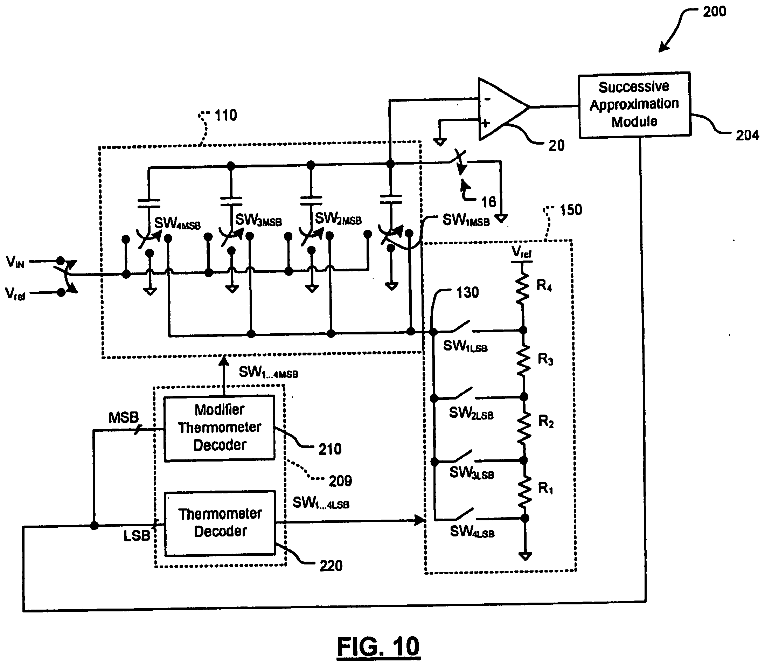

Referring now to FIG. 10, a successive approximation A/D converter 200 is shown. The converter 200 includes a successive approximation register (SAR) 204 or module that contains logic for resolving the digital bits as will be described further below. An output of the SAR 204 is input to decoder module 209 that may include a modified thermometer decoder 210 that communicates with and controls switches $SW_{4MSB}$, $SW_{3MSB}$, $SW_{2MSB}$, and $SW_{1MSB}$ based on MSBs of the output of the SAR. An output of the SAR 204 is input to a thermometer decoder 220 that communicates with and controls switches $SW_{4LSB}$, $SW_{3LSB}$, $SW_{2LSB}$, and $SW_{1LSB}$ based on LSBs in the output of the SAR 204.

During acquisition, the switch 16 is connected to ground. Ends of the capacitors are connected by switches $SW_{MSB}$ to $V_{in}$. After acquisition of $V_{in}$, the switch 16 is opened and the capacitors are disconnected by switches $SW_{MSB}$ from $V_{in}$. The capacitor array is charged with a voltage based on $V_{in}$. The capacitors are then connected to ground by switches $SW_{MSB}$, which drives the common terminal negative to a voltage equal to $-V_{in}$.

As the first step in a binary search algorithm, the capacitive and resistive portions are configured to provide $1/2V_{ref}$ as described above. In other words, $C_{4M}$ is connected to the common node, $C_{3M}$, $C_{2M}$ and $C_{1M}$ are connected to $V_{ref}$ and the switch $SW_{1LSB}$ is closed. For example, if $V_{in}$ is equal to $3/4V_{ref}$, the common terminal will be driven to $(-3/4V_{ref} + 1/2V_{ref}) = -1/4V_{ref}$. When this voltage is compared to ground, the output of the comparator 20 yields a logic '1', implying that $V_{in}$ is greater than $1/2V_{ref}$. If $V_{in}$ is equal to $1/4V_{ref}$, the common terminal voltage is $(-1/4V_{ref} + 1/2V_{ref}) = +1/4V_{ref}$, and the output of the comparator 20 is a logic '0'. This process continues with the next MSB or LSB depending upon the value of the comparator output until all bits are resolved. While capacitive-resistive implementation is shown, capacitive-capacitive, N-stage capacitive or N-stage capacitive-resistive implementations are also contemplated.

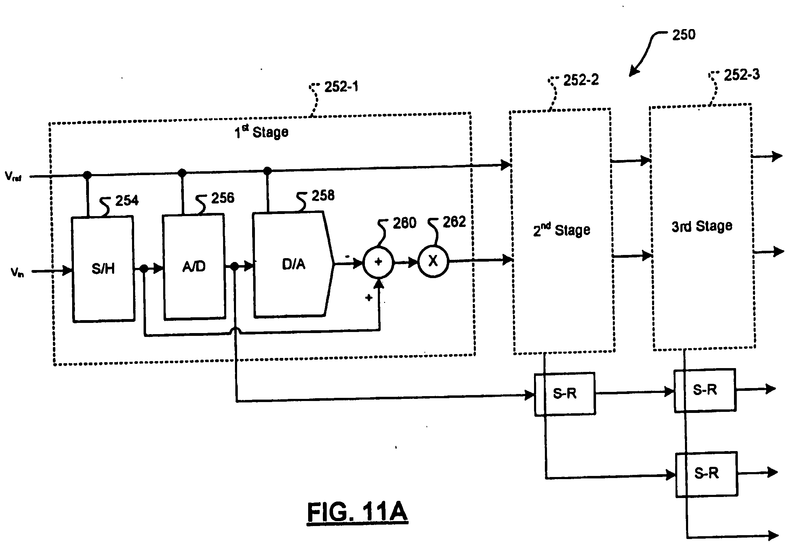

Referring now to FIG. 11A, a pipelined A/D converter 250 is shown. The converter 250 includes a plurality of stages 252-1, 252-2, 252-3 (collectively 252) that are cascaded in series. Each of the course A/D converter stages 252 includes a sample and hold module 254 that samples and holds the analog output signal from a prior stage, a low resolution A/D subconverter module 256 that converts the held analog signal, a low-resolution D/A subconverter module 258 that converts the resulting digital output back into an analog representation, a difference module 260 and an analog interstage difference amplifier module 262 that amplifies the residue. The residue is the difference between the held analog signal and the reconstructed analog signal.

The first stage 252-1 of the pipelined A/D converter 250 operates on a most current analog input sample while the second stage 252-2 operates on the amplified residue of the previous input sample. The concurrency of operations results in a conversion speed that is determined only by the time it takes in one stage.

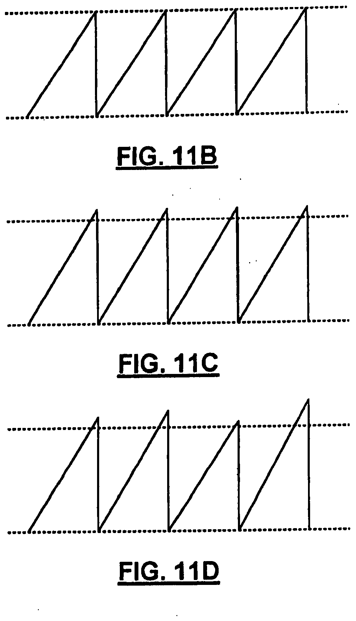

Referring now to FIG. 11B-11D, ideal and non-ideal residue voltages are shown. In FIG. 11B, an ideal residue voltage is shown. When the input reaches a first decision level of the A/D subconverter module 252, the output of the subconverter module switches to its next higher level code causing the output of the D/A subconverter to switch to its next higher level. This in turn causes the amplified residue to drop back to zero.

In actual implementations, however, the components are not ideal and non-uniformity occurs. In FIG. 11C, the residue voltage exceeds the ideal value by a fixed amount. In FIG. 11D, the residue voltage exceeds the ideal residue voltage by a variable amount.

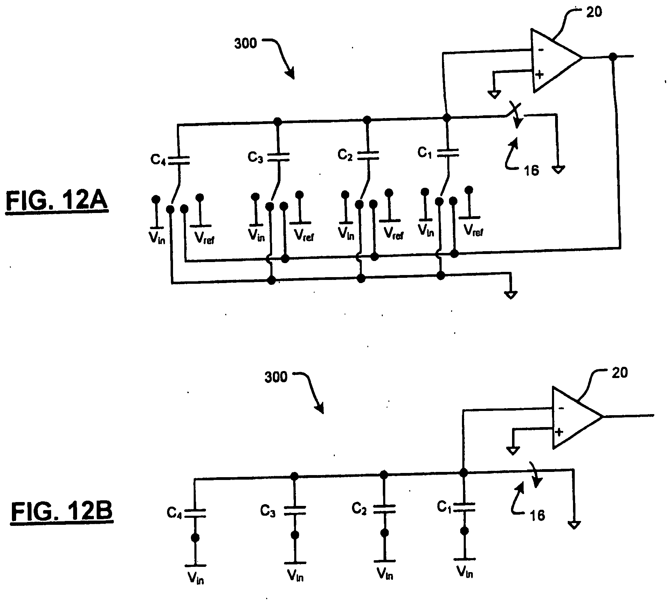

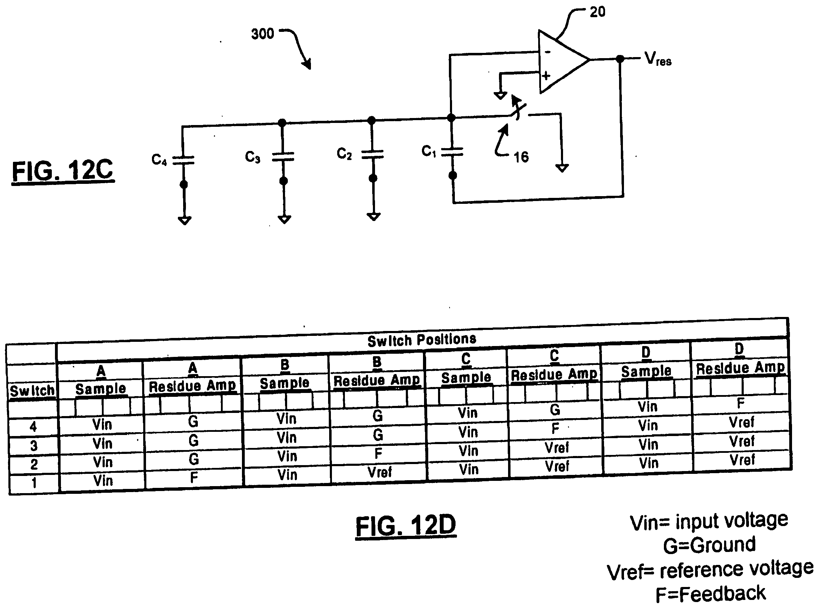

Referring now to FIG. 12A, a digital to analog converter 300 that generates a residue voltage with lower variation according to the present invention is shown. Capacitors $C_1$, $C_2$, $C_3$ and $C_4$ are selectively connected to $V_{in}$, a reference potential such as ground, a voltage reference ($V_{ref}$) and to an output of the opamp 20. In some implementations, $C_1$, $C_2$, $C_3$ and $C_4$ have substantially equal capacitance values.

Referring now to FIGs. 12B-12D, the digital to analog converter of FIG. 12A is shown further. In a sampling phase in FIG. 12B, the switch 16 is closed and the capacitors are connected to $V_{in}$. In a residue amplification stage in FIG. 12B for $V_{in}$ between 0 and $\dfrac{C_1}{C_1 + C_2 + C_3 + C_4}V_{ref}$ ("A" in FIG. 12D), the switch 16 is opened, the capacitor $C_1$ is connected in feedback arrangement. The capacitors $C_2$, $C_3$, and $C_4$ are connected to the reference potential. A truth table is shown in FIG. 12D.

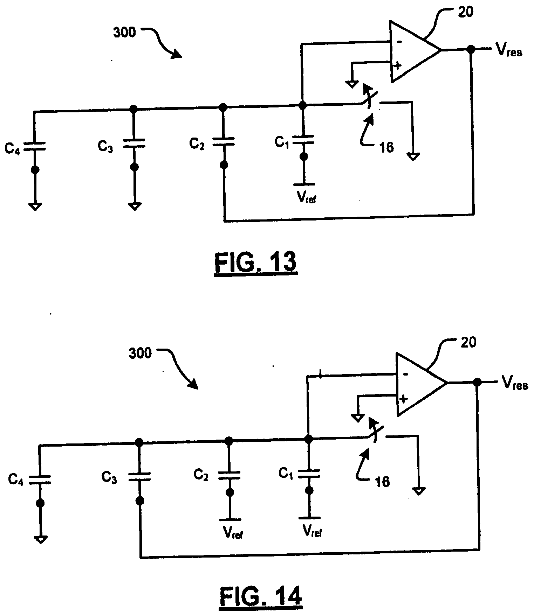

Referring now to FIG. 13, in a residue amplification stage for $V_{in}$ between $\dfrac{C_1}{C_1 + C_2 + C_3 + C_4}V_{ref}$ and $\dfrac{C_1 + C_2}{C_1 + C_2 + C_3 + C_4}V_{ref}$ ("B" in FIG. 12D), the switch 16 is opened, the capacitor $C_2$ is connected in feedback arrangement and the capacitor $C_1$ is connected to $V_{ref}$. The capacitors $C_3$ and $C_4$ are connected to a reference potential.

Referring now to FIG. 14, in a residue amplification stage for $V_{in}$ between $\dfrac{C_1 + C_2}{C_1 + C_2 + C_3 + C_4}V_{ref}$ and $\dfrac{C_1 + C_2 + C_3}{C_1 + C_2 + C_3 + C_4}V_{ref}$ ("C" in FIG. 12D), the switch 16 is opened, the capacitor $C_3$ is connected in feedback arrangement and the capacitors $C_1$ and $C_2$ are connected to $V_{ref}$. The capacitor $C_4$ is connected to a reference potential.

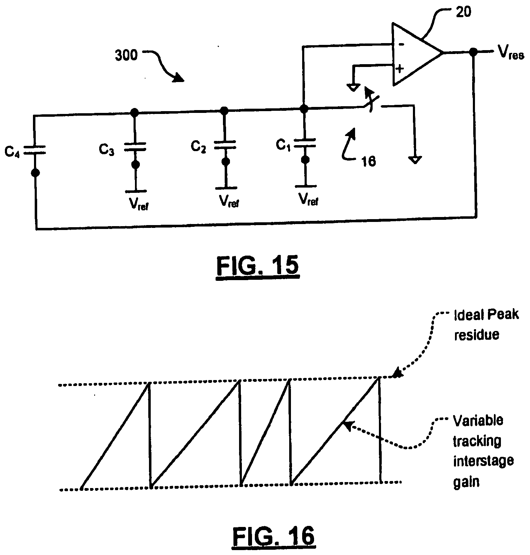

Referring now to FIGs. 15 and 16, in a residue amplification stage for $V_{in}$ between $\dfrac{C_1 + C_2 + C_3}{C_1 + C_2 + C_3 + C_4} V_{ref}$ and $V_{ref}$ ("D" in FIG. 12D), the switch 16 is opened, the capacitor $C_4$ is connected in feedback arrangement and the capacitors $C_1$, $C_2$ and $C_3$ are connected to $V_{ref}$. Note that because the different capacitors are used as the feedback capacitor during residue amplification, the residue gain can perfectly track the capacitor mismatch. The residue voltage now looks as shown in FIG. 16. There is a variable inter-stage gain and a substantially constant maximum residue voltage.

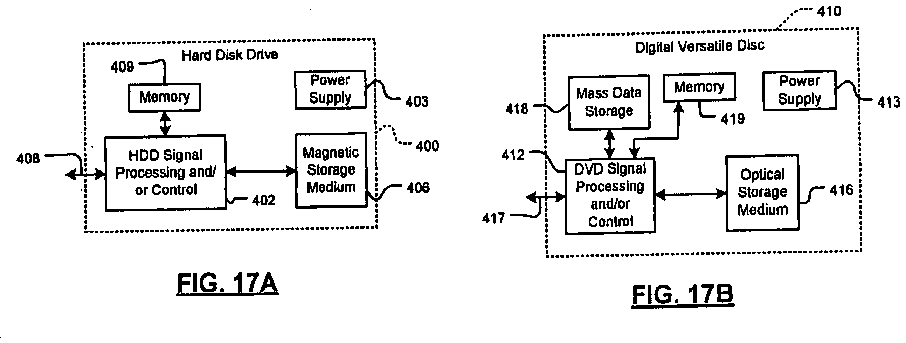

Referring now to FIGs. 17A-17G, various exemplary implementations of the present invention are shown. Referring now to FIG. 17A, the present invention can be implemented in D/A or A/D converters in a hard disk drive 400. In some implementations, the signal processing and/or control circuit 402 and/or other circuits (not shown) in the HDD 400 may process data, perform coding and/or encryption, perform calculations, and/or format data that is output to and/or received from a magnetic storage medium 406.

The HDD 400 may communicate with a host device (not shown) such as a computer, mobile computing devices such as personal digital assistants, cellular phones, media or MP3 players and the like, and/or other devices via one or more wired or wireless communication links 408. The HDD 400 may be connected to memory 409 such as random access memory (RAM), low latency nonvolatile memory such as flash memory, read only memory (ROM) and/or other suitable electronic data storage.

Referring now to FIG. 17B, the present invention can be implemented in D/A or A/D converters in a digital versatile disc (DVD) drive 410. The signal processing and/or control circuit 412 and/or other circuits (not shown) in the DVD 410 may process data, perform coding and/or encryption, perform calculations, and/or format data that is read from and/or data written to an optical storage medium 416. In some implementations, the signal processing and/or control circuit 412 and/or other circuits (not shown) in the DVD 410 can also perform other functions such as encoding and/or decoding and/or any other signal processing functions associated with a DVD drive.

The DVD drive 410 may communicate with an output device (not shown) such as a computer, television or other device via one or more wired or wireless communication links 417. The DVD 410 may communicate with mass data storage 418 that stores data in a nonvolatile manner. The mass data storage 418 may include a hard disk drive (HDD). The HDD may have the configuration shown in FIG. 17A. The HDD may be a mini HDD that includes one or more platters having a diameter that is smaller than approximately 1.8". The DVD 410 may be connected to memory 419 such as RAM, ROM, low latency nonvolatile memory such as flash memory and/or other suitable electronic data storage.

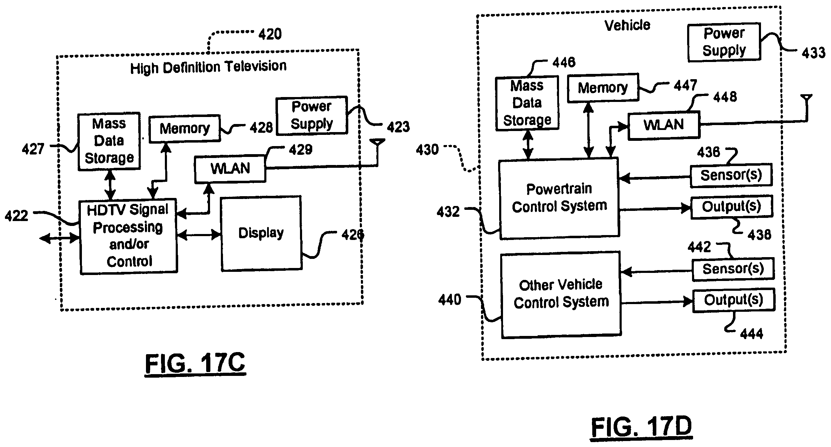

Referring now to FIG. 17C, the present invention can be implemented in D/A or A/D converters in a high definition television (HDTV) 420. The HDTV 420 receives HDTV input signals in either a wired or wireless format and generates HDTV output signals for a display 426. In some implementations, signal processing circuit and/or control circuit 422 and/or other circuits (not shown) of the HDTV 420 may process data, perform coding and/or encryption, perform calculations, format data and/or perform any other type of HDTV processing that may be required.

The HDTV 420 may communicate with mass data storage 427 that stores data in a nonvolatile manner such as optical and/or magnetic storage devices. At least one HDD may have the configuration shown in FIG. 17A and/or at least one DVD may have the configuration shown in FIG. 17B. The HDD may be a mini HDD that includes one or more platters having a diameter that is smaller than approximately 1.8". The HDTV 420 may be connected to memory 428 such as RAM, ROM, low latency nonvolatile memory such as flash memory and/or other suitable electronic data storage. The HDTV 420 also may support connections with a WLAN via a WLAN network interface 429.

Referring now to FIG. 17D, the present invention may implement and/or be implemented in D/A or A/D converters in a control system of a vehicle 430, a WLAN interface, mass data storage of the vehicle control system and/or a power supply 433. In some implementations, the present invention implement a powertrain control system 432 that receives inputs from one or more sensors such as temperature sensors, pressure sensors, rotational sensors, airflow sensors and/or any other suitable sensors and/or that generates one or more output control signals such as engine operating parameters, transmission operating parameters, and/or other control signals.

The present invention may also be implemented in other control systems 440 of the vehicle 430. The control system 440 may likewise receive signals from input sensors 442 and/or output control signals to one or more output devices 444. In some implementations, the control system 440 may be part of an anti-lock braking system (ABS), a navigation system, a telematics system, a vehicle telematics system, a lane departure system, an adaptive cruise control system, a vehicle entertainment system such as a stereo, DVD, compact disc and the like. Still other implementations are contemplated.

The powertrain control system 432 may communicate with mass data storage 446 that stores data in a nonvolatile manner. The mass data storage 446 may include optical and/or magnetic storage devices for example hard disk drives HDD and/or DVDs. At least one HDD may have the configuration shown in FIG. 17A and/or at least one DVD may have the configuration shown in FIG. 17B. The HDD may be a mini HDD that includes one or more platters having a diameter that is smaller than approximately 1.8". The powertrain control system 432 may be connected to memory 447 such as RAM, ROM, low latency nonvolatile memory such as flash memory and/or other suitable electronic data storage. The powertrain control system 432 also may support connections with a WLAN via a WLAN network interface 448. The control system 440 may also include mass data storage, memory and/or a WLAN interface (all not shown).

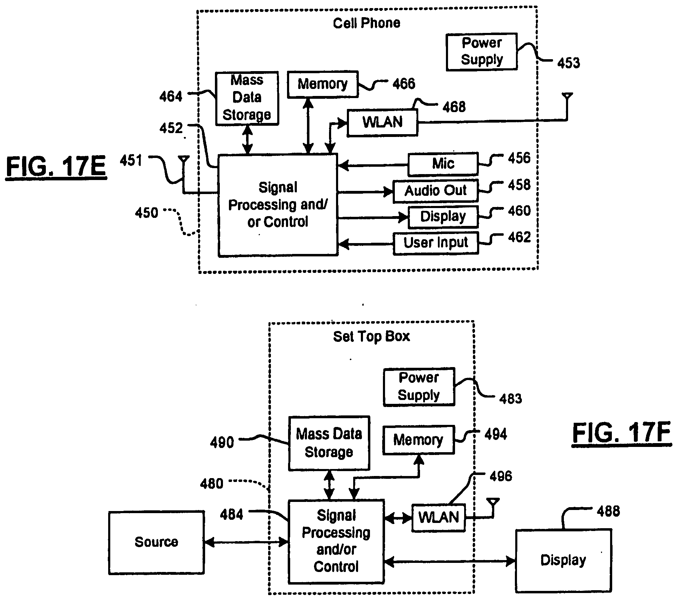

Referring now to FIG. 17E, the present invention can be implemented in D/A or A/D converters in a cellular phone 450 that may include a cellular antenna 451. In some implementations, the cellular phone 450 includes a microphone 456, an audio output 458 such as a speaker and/or audio output jack, a display 460 and/or an input device 462 such as a keypad, pointing device, voice actuation and/or other input device. The signal processing and/or control circuits 452 and/or other circuits (not shown) in the cellular phone 450 may process data, perform coding and/or encryption, perform calculations, format data and/or perform other cellular phone functions.

The cellular phone 450 may communicate with mass data storage 464 that stores data in a nonvolatile manner such as optical and/or magnetic storage devices for example hard disk drives HDD and/or DVDs. At least one HDD may have the configuration shown in FIG. 17A and/or at least one DVD may have the configuration shown in FIG. 17B. The HDD may be a mini HDD that includes one or more platters having a diameter that is smaller than approximately 1.8". The cellular phone 450 may be connected to memory 466 such as RAM, ROM, low latency nonvolatile memory such as flash memory and/or other suitable electronic data storage. The cellular phone 450 also may support connections with a WLAN via a WLAN network interface 468.

Referring now to FIG. 17F, the present invention can be implemented in D/A or A/D converters in a set top box 480. The set top box 480 receives signals from a source such as a broadband source and outputs standard and/or high definition audio/video signals suitable for a display 488 such as a television and/or monitor and/or other video and/or audio output devices. The signal processing and/or control circuits 484 and/or other circuits (not shown) of the set top box 480 may process data, perform coding and/or encryption, perform calculations, format data and/or perform any other set top box function.

The set top box 480 may communicate with mass data storage 490 that stores data in a nonvolatile manner. The mass data storage 490 may include optical and/or magnetic storage devices for example hard disk drives HDD and/or DVDs. At least one HDD may have the configuration shown in FIG. 17A and/or at least one DVD may have the configuration shown in FIG. 17B. The HDD may be a mini HDD that includes one or more platters having a diameter that is smaller than approximately 1.8". The set top box 480 may be connected to memory 494 such as RAM, ROM, low latency nonvolatile memory such as flash memory and/or other suitable electronic data storage. The set top box 480 also may support connections with a WLAN via a WLAN network interface 496.

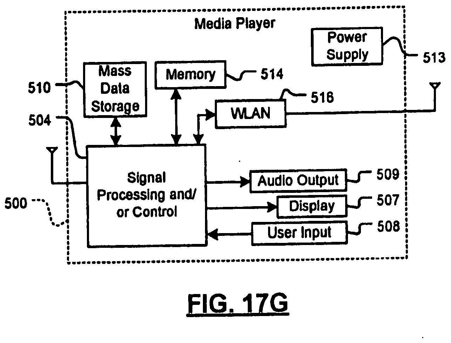

Referring now to FIG. 17G, the present invention can be implemented in D/A or A/D converters in a media player 500. In some implementations, the media player 500 includes a display 507 and/or a user input 508 such as a keypad, touchpad and the like. In some implementations, the media player 500 may employ a graphical user interface (GUI) that typically employs menus, drop down menus, icons and/or a point-and-click interface via the display 507 and/or user input 508. The media player 500 further includes an audio output 509 such as a speaker and/or audio output jack. The signal processing and/or control circuits 504 and/or other circuits (not shown) of the media player 500 may process data, perform coding and/or encryption, perform calculations, format data and/or perform any other media player function.

The media player 500 may communicate with mass data storage 510 that stores data such as compressed audio and/or video content in a nonvolatile manner. In some implementations, the compressed audio files include files that are compliant with MP3 format or other suitable compressed audio and/or video formats. The mass data storage may include optical and/or magnetic storage devices for example hard disk drives HDD and/or DVDs. At least one HDD may have the configuration shown in FIG. 17A and/or at least one DVD may have the configuration shown in FIG. 17B. The HDD may be a mini HDD that includes one or more platters having a diameter that is smaller than approximately 1.8". The media player 500 may be connected to memory 514 such as RAM, ROM, low latency nonvolatile memory such as flash memory and/or other suitable electronic data storage. The media player 500 also may support connections with a WLAN via a WLAN network interface 516. Still other implementations in addition to those described above are contemplated.

## Claims

1. A pipelined analog-to-digital converter, ADC, (250) for converting a signal input (Vin) into a digital value, said ADC (250) comprising a plurality of converter stages (252-1 252-2, 252-3) that are cascaded in series, each converter stage including a sample and hold module (254) that samples and holds the analog signal from the prior stage, the first converter stage (252-1) receiving said input signal (Vin) as an input for its sample and hold module;
each converter stage further comprising:

   an analog to digital converter module (256) for quantizing the analog signal provided by the sample and hold module (254) of the respective converter stage in respect to a reference voltage (Vref),
a digital to analog converter module (258, 300) comprising:

an amplifier (20) having an input and an output;
N capacitances ($C_1$, $C_2$, $C_3$, $C_4$) that are connected in parallel and having substantially the same value and that include first ends that are selectively connected with ground, wherein N is an integer greater than 1, **characterized in that**
N switches that connect second ends of said N capacitances ($C_1$, $C_2$, $C_3$, $C_4$) to said analog signal during a sampling phase,
and selectively connect one of said second ends of said N capacitances ($C_1$, $C_2$, $C_3$, $C_4$) to said output of said amplifier (20), and the others of said second ends of said N capacitances to either ground or said reference voltage (Vref) during a residue amplification phase,
wherein the number of second ends that are connected to ground and second ends that are connected to said reference voltage (Vref) depends on a quantization result provided by said analog to digital converter module (256) of the respective stage, wherein if the ratio between the analog signal provided by the sample and hold module (254) of the respective stage and the reference voltage (Vref) is between 0 and 1/N, connecting all second ends of the other capacitances to ground, and wherein if said ratio is between (N-1)/N and 1 connecting all second ends of all other capacitances to said reference voltage (Vref).

2. The pipelined ADC (250) of claim 1 wherein the number N of capacitances is 4, and wherein
for the ratio between ¼ and ½ the second end of one capacitance of the other capacitances is connected to said reference voltage (Vref), while the second ends of remaining other capacitances are connected to ground,
for the ratio between ½ and ¾ the second ends of two capacitances of the other capacitances are connected to said reference voltage (Vref), while the second end of the remaining capacitance is connected to ground.

**Patentansprüche**

1. Pipeline-Analog-Digital-Wandler (250) zum Umwandeln eines Signaleingangs (Vin) in einen digitalen Wert, wobei der Analog-Digital-Wandler (250) eine Vielzahl von Wandler-Stufen (252-1, 252-2, 252-3) umfasst, die in Reihe hintereinander geschaltet sind, jede Wandler-Stufe ein Abtast-Halte-Modul (254) enthält, das das analoge Signal von der vorhergehenden Stufe abtastet und hält, und die erste Wandler-Stufe (252-1) das Eingangssignal (Vin) als einen Eingang für ihr Abtast-Halte-Modul empfängt;
wobei jede Wandler-Stufe des Weiteren umfasst:

ein Analog-Digital-Wandler-Modul (256) zum Quantisieren des durch das Abtast-Halte-Modul (254) der jeweiligen Wandler-Stufe bereitgestellten analogen Signals in Bezug auf eine Bezugsspannung (Vref),
ein Digital-Analog-Wandler-Modul (258, 300), das umfasst:

einen Verstärker (20), der einen Eingang und einen Ausgang hat;
N Kapazitäten ($C_1$, $C_2$, $C_3$, $C_4$), die parallel verbunden sind und im Wesentlichen den gleichen Wert haben und die erste Enden enthalten, die selektiv mit Erde verbunden werden, wobei N eine ganze Zahl größer als 1 ist,
**dadurch gekennzeichnet, dass**
N Schalter während einer Abtast-Phase zweite Enden der N Kapazitäten ($C_1$, $C_2$, $C_3$, $C_4$) mit dem analogen Signal verbinden,
und während einer Restverstärkungs-Phase eines der zweiten Enden der N Kapazitäten ($C_1$, $C_2$, $C_3$, $C_4$) selektiv mit dem Ausgang des Verstärkers (20) verbinden und die anderen der zweiten Enden der N Kapazitäten entweder mit Erde oder der Bezugsspannung (Vref) verbinden,
wobei die Anzahl zweiter Enden, die mit Erde verbunden werden, und zweiter Enden, die mit der Bezugsspannung (Vref) verbunden werden, von einem Quantisierungsergebnis abhängt, das durch das Analog-Digital-Wandler-Modul (256) der jeweiligen Stufe erbracht wird, wobei, wenn das Verhältnis zwischen dem durch das Abtast-Halte-Modul (254) der jeweiligen Stufe bereitgestellten analogen Signal und der Bezugsspannung (Vref) zwischen 0 und 1/N liegt, alle zweiten Enden der anderen Kapazitäten mit Erde verbunden werden, und, wenn das Verhältnis zwischen (N-1)/N und 1 liegt, alle zweiten Enden aller anderen Kapazitäten mit der Bezugsspannung (Vref) verbunden werden.

2. Pipeline-Analog-Digital-Wandler (250) nach Anspruch 1, wobei die Anzahl N von Kapazitäten 4 beträgt und wobei

bei dem Verhältnis zwischen ¼ und ½ das zweite Ende einer Kapazität der anderen Kapazitäten mit der Bezugsspannung (Vref) verbunden wird, während die zweiten Enden der verbleibenden anderen Kapazitäten mit Erde verbunden werden,

bei dem Verhältnis zwischen ½ und ¾ die zweiten Enden von zwei Kapazitäten der anderen Kapazitäten mit der Bezugsspannung (Vref) verbunden werden, während das zweite Ende der verbleibenden Kapazität mit Erde verbunden wird.

**Revendications**

1. Convertisseur analogique-numérique ADC (250), soit Analog-to-Digital Converter, en chaîne de traitement pour convertir une entrée de signal (Vin) en une valeur numérique, ledit ADC (250) comprenant une pluralité d'étages de convertisseur (252-1 252-2, 252-3) qui sont mis en cascade en série, chaque étage de convertisseur incluant un module d'échantillonnage et de maintien (254) qui échantillonne et maintient le signal analogique provenant de l'étage antérieur, le premier étage de convertisseur (252-1) recevant ledit signal d'entrée (Vin) comme entrée pour son module d'échantillonnage et de maintien ;

   chaque étage de convertisseur comprenant en outre :

   un module de convertisseur analogique-numérique (256) pour quantifier le signal analogique pourvu par le module d'échantillonnage et de maintien (254) de l'étage de convertisseur respectif par rapport à une tension de référence (Vref),
   un module convertisseur numérique-analogique (258, 300) comprenant :

   un amplificateur (20) comportant une entrée et une sortie ;
   N condensateurs ($C_1$, $C_2$, $C_3$, $C_4$) connectés en parallèle, ayant substantiellement la même valeur et incluant des premières extrémités qui sont sélectivement connectées à la terre, dans lequel N est un nombre entier supérieur à 1,
   **caractérisé par**
   N interrupteurs qui connectent des deuxièmes extrémités desdits N condensateurs ($C_1$, $C_2$, $C_3$, $C_4$) audit signal analogique durant une phase d'échantillonnage,
   et qui connectent sélectivement l'une desdites deuxièmes extrémités desdits N condensateurs ($C_1$, $C_2$, $C_3$, $C_4$) à ladite sortie dudit amplificateur (20), et les autres extrémités desdites deuxièmes extrémités desdits N condensateurs soit à la terre, soit à ladite tension de référence (Vref), durant une phase d'amplification résiduelle,
   dans lequel le nombre de deuxièmes extrémités qui sont connectées à la terre et de deuxièmes extrémités qui sont connectées à ladite tension de référence (Vref) dépend d'un résultat de quantification fourni par ledit module convertisseur analogique-numérique (256) de l'étage respectif, dans lequel, si le ratio entre le signal analogique fourni par le module d'échantillonnage et de maintien (254) de l'étage respectif et la tension de référence (Vref) est compris entre 0 et 1/N, toutes les deuxièmes extrémités des autres condensateurs sont connectées à la terre, et dans lequel, si ledit ratio est compris entre (N-1)/N et 1, toutes les deuxièmes extrémités de tous les autres condensateurs sont connectées à ladite tension de référence (Vref).

2. ADC (250) en chaîne de traitement selon la revendication 1 dans lequel le nombre N de condensateurs est égal à 4, et dans lequel

   pour un ratio compris entre ¼ and ½, la deuxième extrémité d'un condensateur parmi les autres condensateurs est connectée à ladite tension de référence (Vref), alors que les deuxièmes extrémités d'autres condensateurs restants sont connectées à la terre,

   pour un ratio compris entre ½ et ¾, les deuxièmes extrémités de deux condensateurs desdits autres condensateurs sont connectées à ladite tension de référence (Vref), alors que la deuxième extrémité du condensateur restant est connectée à la terre.

## FIG. 1A
### Prior Art

## FIG. 1B
### Prior Art

EP 1 770 867 B1

FIG. 2
Prior Art

**FIG. 3A**

FIG. 3B

**FIG. 3C**

FIG. 4A

FIG. 4B

## FIG. 4C

Legend: V = V_ref; C = Node 130; G = Ground; O = Open; C = Closed

| | Code \ Switch | Switch Positions | | | | | | | |
|---|---|---|---|---|---|---|---|---|---|
| | | [0000-0011] Sample | [0000-0011] Integrate | [0100-0111] Sample | [0100-0111] Integrate | [1000-1011] Sample | [1000-1011] Integrate | [1100-1111] Sample | [1100-1111] Integrate |
| MSB 2 bits | SW4MSB | G | G | G | G | G | G | C | G |
| | SW3MSB | G | G | G | G | C | G | V | G |
| | SW2MSB | G | G | C | G | V | G | V | G |
| | SW1MSB | C | G | V | G | V | G | V | G |
| LSB 2 bits | SW4LSB | O O O C | O O O O | O O O C | O O O O | O O O C | O O O O | O O O C | O O O O |
| | SW3LSB | O O C O | O O O O | O O C O | O O O O | O O C O | O O O O | O O C O | O O O O |
| | SW2LSB | O C O O | O O O O | O C O O | O O O O | O C O O | O O O O | O C O O | O O O O |
| | SW1LSB | C O O O | O O O O | C O O O | O O O O | C O O O | O O O O | C O O O | O O O O |

## FIG. 4D

Legend: V = V_ref; C = Node 130; G = Ground; O = Open; C = Closed; A = Amp Output

| | Code \ Switch | Switch Positions | | | | | | | |
|---|---|---|---|---|---|---|---|---|---|
| | | [0000-0011] Sample | [0000-0011] Hold | [0100-0111] Sample | [0100-0111] Hold | [1000-1011] Sample | [1000-1011] Hold | [1100-1111] Sample | [1100-1111] Hold |
| MSB 2 bits | SW4MSB | G | A | G | A | G | A | C | A |
| | SW3MSB | G | A | G | A | C | A | V | A |
| | SW2MSB | G | A | C | A | V | A | V | A |
| | SW1MSB | C | A | V | A | V | A | V | A |
| LSB 2 bits | SW4LSB | O O O C | O O O O | O O O C | O O O O | O O O C | O O O O | O O O C | O O O O |
| | SW3LSB | O O C O | O O O O | O O C O | O O O O | O O C O | O O O O | O O C O | O O O O |
| | SW2LSB | O C O O | O O O O | O C O O | O O O O | O C O O | O O O O | O C O O | O O O O |
| | SW1LSB | C O O O | O O O O | C O O O | O O O O | C O O O | O O O O | C O O O | O O O O |

EP 1 770 867 B1

**FIG. 6**

**FIG. 5**

FIG. 7

EP 1 770 867 B1

## FIG. 8A

EP 1 770 867 B1

FIG. 8B

EP 1 770 867 B1

**FIG. 8C**

**FIG. 8D**

EP 1 770 867 B1

**FIG. 8E**

**FIG. 8F**

FIG. 8G

FIG. 8H

FIG. 8I

## Switch Positions

**Code group [0000-0011]**

| Switch | Sample-LSB | Hold-LSB | Sample-MSB | I or H -MSB |
|---|---|---|---|---|
| **MSB 2 bits** | | | | |
| SW4MSB | G | G | G | G or A |
| SW3MSB | G | G | G | G or A |
| SW2MSB | G | G | G | G or A |
| SW1MSB | G | G | C | G or A |
| **LSB 2 bits** | | | | |
| SW4LSB | G G G G | F F F F F | F F F F | X X X X |
| SW3LSB | G G G V | F F F F F | F F F F | X X X X |
| SW2LSB | G G V V | F F F F F | F F F F | X X X X |
| SW1LSB | G V V V | F F F F F | F F F F | X X X X |

0 to 0.75Vref

**Code group [0100-0111]**

| Switch | Sample-LSB | Hold-LSB | Sample-MSB | I or H -MSB |
|---|---|---|---|---|
| **MSB 2 bits** | | | | |
| SW4MSB | G | G | G | G or A |
| SW3MSB | G | G | C | G or A |
| SW2MSB | G | G | V | G or A |
| SW1MSB | | | | G or A |
| **LSB 2 bits** | | | | |
| SW4LSB | G G G G | X X X X | F F F F | X X X X |
| SW3LSB | G G G V | X X X X | F F F F | X X X X |
| SW2LSB | G G V V | X X X X | F F F F | X X X X |
| SW1LSB | G V V V | X X X X | | |

Vref to 1.75Vref

## Switch Positions

**Code group [1000-1011]**

| Switch | Sample-LSB | Hold-LSB | Sample-MSB | I or H -MSB |
|---|---|---|---|---|
| **MSB 2 bits** | | | | |
| SW4MSB | G | G | G | G or A |
| SW3MSB | G | G | C | G or A |
| SW2MSB | G | G | V | G or A |
| SW1MSB | G | G | V | G or A |
| **LSB 2 bits** | | | | |
| SW4LSB | G G G G | F F F F F | F F F F | X X X X |
| SW3LSB | G G G V | F F F F F | F F F F | X X X X |
| SW2LSB | G G V V | F F F F F | F F F F | X X X X |
| SW1LSB | G V V V | F F F F F | F F F F | X X X X |

2Vref to 2.75Vref

**Code group [11100-1111]**

| Switch | Sample-LSB | Hold-LSB | Sample-MSB | I or H -MSB |
|---|---|---|---|---|
| **MSB 2 bits** | | | | |
| SW4MSB | G | G | C | G or A |
| SW3MSB | G | G | V | G or A |
| SW2MSB | G | G | V | G or A |
| SW1MSB | G | G | V | G or A |
| **LSB 2 bits** | | | | |
| SW4LSB | G G G G | F F F F | F F F F | X X X X |
| SW3LSB | G G G V | F F F F | F F F F | X X X X |
| SW2LSB | G G V V | F F F F | F F F F | X X X X |
| SW1LSB | G V V V | F F F F | F F F F | X X X X |

3Vref to 3.75Vref

V=V_ref
C= Node 130
G=Ground
F=Feedback
X=Don't Care
A = Amp Output

## FIG. 8J

170

BG_X

| Capacitive | — | Output Circuit |

⋮ ⋮

| Capacitive | BG_2

| Capacitive | BG_1

**FIG. 9A**

180

BG_X

| Capacitive | — | Output Circuit |

⋮ ⋮

| Capacitive | BG_{X-Y+1}

| Resistive | BG_{X-Y}

⋮ ⋮

| Resistive | BG_1

**FIG. 9B**

EP 1 770 867 B1

| Sample BG$_1$ | Hold BG$_1$ | Sample BG$_2$ | H or I BG$_2$ | ▪ ▪ ▪ | Sample BG$_N$ | H or I BG$_N$ | Sample BG$_1$ | Hold BG$_1$ | ▪ ▪ ▪ |

Time →

**FIG. 9C**

| Sample BG$_1$ | Hold BG$_1$ | Sample BG$_2$ | H or I BG$_2$ | ▪ ▪ ▪ | Sample BG$_N$ | H or I BG$_N$ |

| Sample BG$_1$ | Hold BG$_1$ | ▪ ▪ ▪ |

Time →

**FIG. 9D**

**FIG. 10**

**FIG. 11A**

**FIG. 11B**

**FIG. 11C**

**FIG. 11D**

EP 1 770 867 B1

FIG. 12A

FIG. 12B

## FIG. 12C

## FIG. 12D

| Switch | A Sample | A Residue Amp | B Sample | B Residue Amp | C Sample | C Residue Amp | D Sample | D Residue Amp |
|---|---|---|---|---|---|---|---|---|
| 4 | Vin | G | Vin | G | Vin | G | Vin | F |
| 3 | Vin | G | Vin | G | Vin | F | Vin | Vref |
| 2 | Vin | G | Vin | F | Vin | Vref | Vin | Vref |
| 1 | Vin | F | Vin | Vref | Vin | Vref | Vin | Vref |

Switch Positions

Vin= input voltage
G=Ground
Vref= reference voltage
F=Feedback

EP 1 770 867 B1

**FIG. 13**

**FIG. 14**

EP 1 770 867 B1

**FIG. 15**

- Ideal Peak residue

- Variable tracking interstage gain

**FIG. 16**

EP 1 770 867 B1

EP 1 770 867 B1

**Digital Versatile Disc**

Power Supply — 413

Memory — 419

Mass Data Storage — 418

DVD Signal Processing and/or Control — 412

Optical Storage Medium — 416

410

417

**FIG. 17B**

**Hard Disk Drive**

Power Supply — 403

400

Memory — 409

HDD Signal Processing and/or Control — 402

Magnetic Storage Medium — 406

408

**FIG. 17A**

41

EP 1 770 867 B1

420

High Definition Television

Mass Data Storage — 427

Memory — 428

Power Supply

423

WLAN — 429

HDTV Signal Processing and/or Control — 422

Display — 426

**FIG. 17C**

Vehicle

Power Supply — 433

Mass Data Storage — 446

Memory — 447

WLAN — 448

430

Powertrain Control System — 432

Sensor(s) — 436

Output(s) — 438

Other Vehicle Control System — 440

Sensor(s) — 442

Output(s) — 444

**FIG. 17D**

EP 1 770 867 B1

**FIG. 17E**

Cell Phone

Power Supply ~ 453

464 — Mass Data Storage

Memory ~ 466

468

452 ~

WLAN

451

Signal Processing and/or Control

Mic ~ 456

Audio Out ~ 458

Display ~ 460

User Input ~ 462

450

**FIG. 17F**

Set Top Box

Power Supply ~ 483

490 ~ Mass Data Storage

Memory ~ 494

496

480

484 —

Source

Signal Processing and/or Control

WLAN

Display ~ 488

**FIG. 17G**

EP 1 770 867 B1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 71507805 P
- US 6839015 B1
- US 2005078026 A1
- US 2003080893 A1
- WO 2005041418 A
- WO 0184717 A1
- US 6822601 B1
- JP 10075176 A
- US 6441765 B1

### Non-patent literature cited in the description

- **RUNHUA SUN et al.** A pipelined A/D converter for high-speed and high-resolution application. IEEE, 2002, I-917-I-920